(19) **Europäisches Patentamt / European Patent Office / Office européen des brevets**

(11) **EP 4 644 344 A1**

(12) **EUROPEAN PATENT APPLICATION**
published in accordance with Art. 153(4) EPC

(43) Date of publication:
05.11.2025 Bulletin 2025/45

(21) Application number: 23909034.3

(22) Date of filing: 21.06.2023

(51) International Patent Classification (IPC):
C03C 10/06 (2006.01)    C03C 10/02 (2006.01)

(52) Cooperative Patent Classification (CPC):
C03C 10/00; C03C 21/00

(86) International application number:
PCT/CN2023/101602

(87) International publication number:
WO 2024/139088 (04.07.2024 Gazette 2024/27)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 30.12.2022 CN 202211738867

(71) Applicant: Chongqing Aureavia Hi-Tech Glass Co., Ltd.
Chongqing 400714 (CN)

(72) Inventors:
• HUANG, Hao
  Chongqing 400714 (CN)

• XIE, Xiaolan
  Chongqing 400714 (CN)
• ZHOU, Jingpeng
  Chongqing 400714 (CN)
• TIAN, Qian
  Chongqing 400714 (CN)
• XIANG, Wenhao
  Chongqing 400714 (CN)
• CHEN, Ying
  Chongqing 400714 (CN)

(74) Representative: terpatent PartGmbB
Burgunderstraße 29
40549 Düsseldorf (DE)

(54) **LITHIUM-FREE TRANSPARENT SPINEL MICROCRYSTALLINE GLASS, PREPARATION METHOD THEREFOR, AND APPLICATION THEREOF**

(57) A lithium-free transparent spinel glass ceramic and preparation method therefor and use thereof. The lithium-free transparent spinel glass ceramic is prepared from a base glass by heat treatment, and a spinel crystal is the main crystalline phase. The composition of the glass ceramic comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$ 3.00 to 8.00 mol%, $K_2O$ 0 to 2.00 mol% and $Y_2O_3$ 0 to 1.00 mol%, and is substantially free of $Li_2O$. The lithium-free transparent spinel glass ceramic does not use high-cost lithium, and can achieve excellent surface stress characteristics and deep-layer stress characteristics through chemical strengthening, thereby obtaining an excellent drop resistance performance.

**FIG. 1**

## Description

### RELATED APPLICATION

This application claims priority to the prior application document No. 202211738867.8 filed before the China National Intellectual Property Administration on December 30, 2022, which is incorporated herein in its entirety.

### FIELD OF THE INVENTION

The present application relates to the technical field of glass ceramic technology, in particular to a lithium-free transparent spinel glass ceramic that can be chemically strengthened and a preparation method therefor and use thereof.

### BACKGROUND OF THE INVENTION

With the gradual thinning and lightening of electronic devices, the performance requirements for cover glass are increasing. For an electronic cover glass, excellent surface stress characteristics and excellent deep-layer stress characteristics are required to achieve a high mechanical performance. Among them, the excellent deep-layer stress characteristics are necessary conditions for a cover glass to achieve an excellent impact resistance performance, such as an excellent drop resistance performance.

Glass ceramic (microcrystalline glass) material, by virtue of their excellent mechanical performance and photopermeability, has become a better choice for screen covers. Among various glass ceramics, spinel glass ceramic with spinel as the main crystalline phase has gradually received the attention of those in the industry because of its high Young modulus and shear modulus.

In order to make spinel glass ceramic meet the requirements of screen covers, researchers have attempted to perform chemical strengthening and toughening on it. The main way is to introduce lithium oxide and/or sodium oxide into the base glass first, followed by achieving chemical strengthening via an ion exchange between lithium ions in the base glass and sodium ions in a salt bath, and/or an ion exchange between sodium ions in the base glass and potassium ions in a salt bath.

The inventors found through research that: there are a lot of disadvantages in using lithium ions to achieve chemical strengthening and toughening. Firstly, the radius difference between Li ions and Na ions is about 22 pm, and the radius difference between Na ions and K ions is about 40 pm. The generation of stress performance is due to the "crowding" effect formed by ion exchange. Therefore, under the same ion exchange amount, the stress performance generated by the ion exchange between Li ions and Na ions is far inferior to the stress performance generated by the ion exchange between Na ions and K ions. Secondly, a higher content of lithium oxide needs to be added to the base glass when relying on the ion exchange between Li ions and Na ions to achieve a high stress performance. However, $Li_2O$ is expensive, and the use of a large amount of lithium oxide will lead to a high cost of the glass. Thirdly, a large amount of Li present in the base glass can easily lead to precipitation of impurity phases, such as quartz and quartz solid solutions, during the heat treatment process of the base glass for obtaining the glass-ceramic, which can affect the transmittance of the glass ceramic, leading to deterioration in optical performance of the glass ceramic.

Further, for the schemes of using sodium ions to achieve chemical strengthening and toughening in the prior art, the inventors found that they will lead to poor deep-layer stress characteristics and an unsatisfactory drop impact resistance. For example, Chinese Patent CN111908793A discloses a glass ceramic with a spinel crystalline phase, having the following composition: $SiO_2$: 50 to 70 mol%, $Al_2O_3$: 5 to 21 mol%, $Na_2O$: 6 to 21 mol%, ZnO: 2 to 12 mol%, $TiO_2$: 0.5 to 10 mol%, MgO: 0 to 10 mol%; wherein a large amount of $Na_2O$ is added. However, after chemical strengthening, the glass ceramic can only achieve a depth of compressive stress layer of no more than 40 $\mu$m, and has poor deep-layer stress characteristics. Thus, the chemically strengthened glass ceramic is very easy to break after drop impact, failing to achieve an excellent drop impact resistance.

In addition, the inventors also found that the required heat treatment temperatures, such as crystallization temperatures, in the preparation of existing transparent spinel glass ceramic are usually at 900 °C or even higher. This has greatly restricted the mass production of the spinel glass ceramic, and conventional roller hearth furnaces cannot perform the mass production successfully.

### SUMMARY OF THE INVENTION

Based on the above researches, to improve economic benefits, and at the same time to avoid the disadvantages of using lithium ions to achieve the chemical strengthening and toughening in spinel glass ceramic, the inventors thought of using sodium ions instead of using lithium oxide to achieve the chemical strengthening and toughening of spinel glass ceramic.

However, the transparent spinel glass ceramic in the prior art, which are chemically strengthened and toughened only through sodium ions, has a problem of poor drop resistance performance and failing to meet the requirements of screen covers for drop impact performance. In addition, the existing transparent spinel glass ceramic has a crystallization temperature of higher than 900 °C, leading to an impaired mass production performance.

After in-depth researches, the inventors found that the reason why the existing spinel glass ceramic containing only Na fails to achieve a higher depth of stress layer, has poor deep-layer stress characteristics and poor drop resistance performance after chemical strengthening is mainly due to the microstructure of the existing spinel glass ceramic, which limits the depth of Na ions entering the interior of the glass and affects the possible depth of the ion exchange between Na ions and K ions. The volume of a $[AlO_4]$ tetrahedron is larger than that of $[SiO_4]$, and theoretically, if the content of $Al_2O_3$ is increased, the ion exchange channels shall be broadened, promoting the diffusion of Na ions. However, the inventors found that a significant increase in $Al_2O_3$ amount would lead to a significant increase in the difficulty of melting the base glass, especially in the absence of the fluxing of $Li_2O$. This is because $Na_2O$ is not as effective as $Li_2O$ in fluxing, whereas $Al_2O_3$ is more difficult to melt than $SiO_2$. Introducing a large amount of $Na_2O$ to aid melting will lead to an uncontrollable crystallization, as well as a ceramization of the base glass during molding or annealing processes.

In this regard, the inventors modified the formulation continuously, adjusting the amount of each oxide in the formulation and the relationship between the amount of each oxide, optimizing the glass formulation, taking into account melting performances, stress performances, optical performances and mechanical performances, and ultimately developed a lithium-free transparent spinel glass ceramic with a specific structure, a good overall uniformity, and a high intrinsic strength. The glass ceramic not only has a lower preparation cost than the existing lithium-containing spinel glass ceramic, an excellent optical performance, and a high intrinsic strength, but also can be chemically strengthened to obtain a strengthened glass ceramic with excellent surface stress characteristics and deep-layer stress characteristics, which in turn makes the strengthened glass ceramic having excellent mechanical performances, such as an excellent drop impact resistance performance. Moreover, the base glass corresponding to the optimized glass formulation of the present application can obtain, at a heat treatment temperature of no more than 800 °C, a transparent glass ceramic with a main crystalline phase of zinc-magnesium spinel solid solution and having an excellent optical performance and a high intrinsic strength. Compared with the prior art, the optimized formulation of spinel glass ceramic of the present application can significantly reduce the heat treatment temperature required for the preparation of the target glass ceramic, which is in line with the development demand of the industry for energy efficiency and carbon reduction, improves the manufacturability of transparent spinel glass ceramic, and ensures an excellent optical performance and a high intrinsic strength of the glass ceramic.

Specifically, the present application provides the following technical solutions.

In a first aspect, the present application provides a lithium-free transparent spinel glass ceramic. The lithium-free transparent spinel glass ceramic is prepared from a base glass by heat treatment. The lithium-free transparent spinel glass ceramic comprises a spinel crystal, and the spinel crystal is the main crystalline phase of the glass ceramic.

The composition of the lithium-free transparent spinel glass ceramic comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$ 3.00 to 8.00 mol%, $K_2O$ 0 to 2.00 mol% and $Y_2O_3$ 0 to 1.00 mol%; and wherein the lithium-free transparent spinel glass ceramic is substantially free of $Li_2O$, with less than 0.01% $Li_2O$ in mol%.

In some embodiments of the present application, the composition of the lithium-free transparent spinel glass ceramic comprises the following oxides in mol%: $SiO_2$ 38.00 to 44.00 mol%, $Al_2O_3$ 25.50 to 30.00 mol%, $ZrO_2$ 3.00 to 4.00 mol%, MgO 5.00 to 7.00 mol%, ZnO 8.00 to 12.00 mol%, $Na_2O$ 7.20 to 13.00 mol%, $B_2O_3$ 3.00 to 7.00 mol%, $K_2O$ 0 to 2.00 mol% and $Y_2O_3$ 0 to 1.00 mol%.

In some embodiments of the present application, in molar percentage of each oxide in the composition of the lithium-free transparent spinel glass ceramic, the composition of the lithium-free transparent spinel glass ceramic satisfies:

for an A-value calculated based on the following formula (1), the A-value is less than or equal to 0.18, and preferably the A-value is 0.05 to 0.15,

$$(1)\ A=0.65\times Al_2O_3+3.5\times ZrO_2-0.8\times Na_2O-2.5\times B_2O_3;$$

and/or,

for a B-value calculated based on the following formula (2), the B-value is less than or equal to 0.80, and preferably the B-value is 0.60 to 0.78,

$$(2)\ B=3.8\times Na_2O+B_2O_3+4.5\times MgO+6.0\times ZnO-0.4\times Al_2O_3-SiO_2.$$

In some embodiments of the present application, the molar percentage of $Na_2O$ is 7.20 to 12.00 mol%;

and/or, the molar percentage of $Al_2O_3$ is 25.50 to 28.00 mol%;
and/or, the molar percentage of MgO is 5.00 to 6.50 mol%;
and/or, the molar percentage of ZnO is 8.00 to 10.50 mol%;
and/or, the molar percentage of $B_2O_3$ is 3.00 to 6.50 mol%.

In some embodiments of the present application, in the lithium-free transparent spinel glass ceramic, the molar percentage of each of components $Al_2O_3$, MgO and ZnO satisfies the following relationship: $Al_2O_3$-MgO-ZnO = 8.00 to 15.00 mol%.

In some embodiments of the present application, in molar percentage of each oxide in the composition of the lithium-free transparent spinel glass ceramic, the composition of the lithium-free transparent spinel glass ceramic satisfies:

for an X-value calculated based on the following formula (3), the X-value is 30.00 to 50.00%, and preferably the X-value is 34.00 to 46.00%,

$$(3)\ X=2.1\times(Al_2O_3\text{-}MgO\text{-}ZnO)/(SiO_2+Al_2O_3\text{-}MgO\text{-}ZnO+Na_2O+K_2O+B_2O_3);$$

and/or,
for a Y-value calculated based on the following formula (4), the Y-value is 60.00 to 80.00%, and preferably the Y-value is 60.00 to 75.00%,

$$(4)\ Y=(2.7\times Na_2O+1.8\times(Al_2O_3\text{-}MgO\text{-}ZnO))/(SiO_2+Al_2O_3\text{-}MgO\text{-}ZnO+Na_2O+K_2O+B_2O_3).$$

In some embodiments of the present application, the spinel crystal is $(Zn, Mg)Al_2O_4$; and/or, the lithium-free transparent spinel glass ceramic further comprises tetragonal zirconia as a secondary crystalline phase.

In some embodiments of the present application, the crystallinity of the lithium-free transparent spinel glass ceramic is $\geq$ 20.00 wt.%; preferably, the crystallinity is 20.00 to 50.00 wt.%; further preferably, the crystallinity is 30.00 to 50.00 wt.%; more preferably, the crystallinity is 35.00 to 45.00 wt.%.

In some embodiments of the present application, in the lithium-free transparent spinel glass ceramic, the average grain size is $\leq$ 15.0 nm, preferably 1.0 to 15.0 nm, further preferably 1.0 to 10.0 nm, and more preferably 4.5 to 8.0 nm.

In some embodiments of the present application, for light at a wavelength of 550 nm, the transmittance of the lithium-free transparent spinel glass ceramic with a thickness of 0.7 mm is greater than or equal to 85%, preferably greater than or equal to 89%.

In some embodiments of the present application, the Young modulus of the lithium-free transparent spinel glass ceramic is $\geq$ 100 GPa, preferably, the Young modulus is $\geq$ 110 GPa, and more preferably, 114 GPa $\leq$ Young modulus $\leq$ 140 GPa.

In some embodiments of the present application, the optical b-value of the lithium-free transparent spinel glass ceramic with a thickness of 0.7 mm is 0.20 to 1.50, preferably 0.50 to 1.20.

In some embodiments of the present application, the lithium-free transparent spinel glass ceramic is substantially free of BaO, with less than 0.01% BaO in mol%;

and/or, the lithium-free transparent spinel glass ceramic is substantially free of $TiO_2$, with less than 0.01% $TiO_2$ in mol%.

In a second aspect, the present application also provides a preparation method of the above lithium-free transparent spinel glass ceramic, comprising the step of: subjecting a base glass to a heat treatment to form the lithium-free transparent spinel glass ceramic;

wherein the lithium-free transparent spinel glass ceramic comprises a spinel crystal, and the spinel crystal is the main crystalline phase of the lithium-free transparent spinel glass ceramic;
the composition of the lithium-free transparent spinel glass ceramic comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$ 3.00 to 8.00 mol%, $K_2O$ 0 to 2.00 mol% and $Y_2O_3$ 0 to 1.00 mol%;
wherein the lithium-free transparent spinel glass ceramic is substantially free of $Li_2O$, with less than 0.01% $Li_2O$ in mol%.

In some embodiments of the present application, the heat treatment in the above preparation method comprises a nucleation treatment and/or a crystallization treatment; wherein:

the nucleation treatment temperature is 600 to 850 °C, preferably 600 to 750 °C, and preferably, the nucleation treatment time is 0 to 72 h, preferably 0 to 24 h;

and/or, the crystallization treatment temperature is 700 to 1000 °C, preferably 700 to 800 °C, and preferably, the crystallization treatment time is 0.1 to 72 h, preferably 0.1 to 24 h; and/or,

during the heat treatment, the heating rate is controlled to be 5 to 15 K/min.

In some embodiments of the present application, in the above preparation method, in molar percentage of each oxide in the composition of the lithium-free transparent spinel glass ceramic, the composition of the lithium-free transparent spinel glass ceramic satisfies:

$$A = 0.65 \times Al_2O_3 + 3.5 \times ZrO_2 - 0.8 \times Na_2O - 2.5 \times B_2O_3,$$

wherein $A \leq 0.18$, and preferably the A-value is 0.05 to 0.15;

and/or, $B = 3.8 \times Na_2O + B_2O_3 + 4.5 \times MgO + 6.0 \times ZnO - 0.4 \times Al_2O_3 - SiO_2$, wherein $B \leq 0.80$, and preferably the B-value is 0.60 to 0.78;

and/or, $X = 2.1 \times (Al_2O_3-MgO-ZnO)/(SiO_2+Al_2O_3-MgO-ZnO+Na_2O+K_2O+B_2O_3)$, wherein X=30.00 to 50.00%, and preferably X=34.00 to 46.00%;

and/or, $Y = (2.7 \times Na_2O + 1.8 \times (Al_2O_3-MgO-ZnO))/(SiO_2+Al_2O_3-MgO-ZnO+Na_2O+K_2O+B_2O_3)$, wherein Y= 60.00 to 80.00%, and preferably Y=60.00 to 75.00%;

and/or, in the lithium-free transparent spinel glass ceramic, the molar percentage of each of components $Al_2O_3$, MgO and ZnO satisfies the following relationship: $Al_2O_3$-MgO-ZnO = 8.00 to 15.00 mol%.

In some embodiments of the present application, in the above preparation method, the lithium-free transparent spinel glass ceramic is substantially free of BaO, with less than 0.01% BaO in mol%; and/or,

the lithium-free transparent spinel glass ceramic is substantially free of $TiO_2$, with less than 0.01% $TiO_2$ in mol%.

In a third aspect, the present application also provides a base glass for preparing the above lithium-free transparent spinel glass ceramic, and the composition of the base glass comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$ 3.00 to 8.00 mol%, $K_2O$ 0 to 2.00 mol% and $Y_2O_3$ 0 to 1.00 mol%; wherein the base glass is substantially free of $Li_2O$, with less than 0.01% $Li_2O$ in mol%.

In some embodiments of the present application, in molar percentage of each oxide in the composition of the base glass, the composition of the base glass satisfies:

$A = 0.65 \times Al_2O_3 + 3.5 \times ZrO_2 - 0.8 \times Na_2O - 2.5 \times B_2O_3$, wherein $A \leq 0.18$, and preferably the A-value is 0.05 to 0.15;

and/or, $B = 3.8 \times Na_2O + B_2O_3 + 4.5 \times MgO + 6.0 \times ZnO - 0.4 \times Al_2O_3 - SiO_2$, wherein $B \leq 0.80$, and preferably the B-value is 0.60 to 0.78;

and/or, $X = 2.1 \times (Al_2O_3-MgO-ZnO)/(SiO_2+Al_2O_3-MgO-ZnO+Na_2O+K_2O+B_2O_3)$, wherein X=30.00 to 50.00%, and preferably X=34.00 to 46.00%;

and/or, $Y = (2.7 \times Na_2 + O1.8 \times (Al_2O_3-MgO-ZnO))/(SiO_2+Al_2O_3-MgO-ZnO+Na_2O+K_2O+B_2O_3)$, wherein Y= 60.00 to 80.00%, preferably Y=60.00 to 75.00%;

and/or, in the base glass, the molar percentage of each of components $Al_2O_3$, MgO and ZnO satisfies the following relationship: $Al_2O_3$-MgO-ZnO = 8.00 to 15.00 mol%.

In some embodiments of the present application, the base glass is substantially free of BaO, with less than 0.01% BaO in mol%; and/or,

the base glass is substantially free of $TiO_2$, with less than 0.01% $TiO_2$ in mol%.

In a fourth aspect, the present application also provides a chemically strengthened glass, comprising a chemically strengthened glass obtained by subjecting the above lithium-free transparent spinel glass ceramic, or a lithium-free transparent spinel glass ceramic prepared by the above preparation method, or the above base glass, to a chemical strengthening treatment.

In a fifth aspect, the present application also provides use of the above lithium-free transparent spinel glass ceramic, or a lithium-free transparent spinel glass ceramic prepared by the above preparation method, or the above base glass, or the above chemically strengthened glass, in a mobile phone display screen, a tablet computer display screen, a hand-held game console, an electronic terminal, a portable digital device, a vehicle center control screen, an electronic whiteboard glass, a smart home touch screen, a vehicle windshield glass, a flight vehicle windshield glass, or an aircraft windshield glass.

Beneficial Effects of the Present Application

1. The lithium-free transparent spinel glass ceramic provided by the present application has good economic benefits. On one hand, the glass ceramic of the present application does not require the use of high-cost lithium, yet it can still achieve excellent surface stress characteristics and deep-layer stress characteristics through chemical strengthening, as well as an excellent drop resistance performance. On the other hand, the base glass corresponding to the optimized glass formulation of the present application has low melting difficulty and is not easy to generate melting defects, and it allows to obtain a transparent glass ceramic with a main crystalline phase of zinc-magnesium spinel solid solution and having excellent optical performance and high intrinsic strength, with a heat treatment temperature of no more than 800 °C. This greatly reduces the difficulty of mass production of transparent spinel glass ceramic, and the possibility of mass production is higher, which is in line with the development demand of the industry for energy efficiency and carbon reduction.

2. The lithium-free transparent spinel glass ceramic provided by the present application has a high intrinsic strength and can be chemically strengthened to obtain a strengthened glass ceramic with an excellent drop impact resistance performance, which is capable of meeting the using requirements for the cover glass of electronic devices. The present application, by adjusting the amount of the oxides in the formulation and the relationship between the amounts of the oxides, utilizes the synergistic cooperation of the oxide components with specific amounts, not only obtained the target main crystalline phase $(Zn, Mg)Al_2O_4$ in a desired content, but also results in a specific network structure of the glass ceramic. The intrinsic strength of the glass ceramic is greatly improved by making a large amount of the main crystalline phases $(Zn, Mg)Al_2O_4$ with a high Young modulus and a high shear modulus uniformly distributed in the specific glass network structure. On this basis, through a chemical strengthening of the glass ceramic, it is possible to obtain a strengthened glass ceramic with excellent surface stress characteristics and excellent deep-layer stress characteristics. The combination of the high intrinsic strength with the excellent surface stress characteristics and deep-layer stress characteristics endows the strengthened glass ceramic excellent mechanical performances, and makes the strengthened glass ceramic possessing an excellent drop impact resistance.

## BRIEF DESCRIPTION OF THE DRAWING

FIG. 1 shows a result of the melting process of the base glass in Example 1.

FIG. 2 shows a result of the melting process of the base glass in Example 3.

FIG. 3 shows a result of the melting process of the base glass in Example 4.

FIG. 4 shows an appearance of the lithium-free transparent spinel glass ceramic in Example 4.

FIG. 5 shows an appearance of the lithium-free transparent spinel glass ceramic in Example 5.

FIG. 6 shows a thermogravimetric analysis profile of the base glass of Example 1.

FIG. 7 shows an X-ray diffraction pattern of the lithium-free transparent spinel glass ceramic in Example 1.

FIG. 8 shows a transmittance profile of the lithium-free transparent spinel glass ceramic in Example 5 under different wavelength conditions.

FIG. 9 shows a result of the melting process of the base glass in Comparative Example 1.

FIG. 10 shows a result of the melting process of the base glass in Comparative Example 2.

FIG. 11 shows a result of the melting process of the base glass in Comparative Example 3.

FIG. 12 shows a result of the melting process of the base glass in Comparative Example 6.

FIG. 13 shows an appearance of the glass ceramic in Comparative Example 19.

## DETAILED DESCRIPTION OF THE INVENTION

After repeated experiments and research, the inventors prepared a lithium-free transparent spinel glass ceramic that taking into account the melting performance, stress performance, optical performance, and mechanical performance, collectively, by specifying the content and the proportion of the content of the specific components that constitutes the glass ceramic as specific proportional relationships.

In the present application, unless specifically indicated otherwise in specific instances, the numerical ranges set forth herein include the upper and lower limits. The terms "above" and "below" include endpoints, as well as all integers and fractions within such ranges, without limitation to the specific values set forth in the limited ranges. The term "and/or" as used herein is inclusive; e.g., "A; and/or B" refers to only A, or only B, or both A and B.

As used herein, when used to describe constituent components of compositions, batches, melts, or articles, the phrases "substantially free of" or "free of" refers to a constituent component that is not intentionally added or formulated into the compositions, batches, melts, or articles, but may be present as a constituent component in a small amount of less than about 0.01% (in molar percentage of oxides). It is a contaminant and/or is due to the inherent degree of uncertainty attributed to any measurement or analytical technique.

In the present application, glass ceramic, also known as microcrystalline glass, is a type of solid composite materials comprising both glass phases and crystal phases (also known as microcrystal phases, crystallization phases, or crystalline phase), prepared by subjecting a base glass to a targeted and controlled heat treatment.

In the present application, base glass refers to a glass that has not been subjected to nucleation, crystallization and strengthening.

In the present application, chemically strengthened glass refers to a solid composite material obtained after subjecting a base glass or glass ceramic to a chemical strengthening. The glass ceramic is chemically strengthened to obtain a strengthened glass ceramic.

It should be understood that when performing a high-temperature chemical strengthening treatment, alkali metal ions having a larger ionic radius (e.g., potassium ions, sodium ions) in a salt bath/molten salt will displace those alkali metal ions having a smaller ionic radius (e.g., sodium ions, lithium ions) in the base glass or the glass ceramic, resulting in a volume difference in the exchanged ions and creating compression stress on the glass surface.

In the present application, nucleation treatment refers to a process which allows growth of small crystal nucleus of nucleating substances in glass by heat treatment; and crystallization treatment refers to a process which allows growth of a certain crystal on the basis of the crystal nucleus by heat treatment.

In the present application, the nucleation temperature is the temperature at which the crystal nucleus is formed.

In the present application, the crystallization temperature is the temperature at which the growth rate of the target crystal is controllable.

In the present application, the optical b-value indicates the yellow-blue value of a material. In the present application, the optical b-value is the b-value of transmitted light, in which a positive optical b-value indicates that the material is bluish.

Transmittance refers to a ratio of radiant energy that is projected onto and transmitted through an object to the total radiant energy projected onto the object during the process where incident luminous flux enters from the illuminated surface or medium incident surface and exits from the other surface. It should be understood that when a light at a certain wavelength irradiates to a glass surface, the light will be reflected, absorbed and transmitted. The transmittance is defined as the ratio of the intensity of the transmitted portion to that of the incident light.

In the present application, the transmittance result of the glass ceramic at a wavelength of 550 nm refers to an average of the transmittance measured at the wavelength of 550 nm for a plurality of glass samples from the same batch. At least 5 samples of glass-ceramic from each batch are taken for testing. In the present application, the transmittance of each glass sample at the wavelength of 550 nm is tested by Konica Minolta spectrophotometer CM-3600A, Japan.

In the present application, fogging refers to a semi-transparent state, which is an intermediate state between transparency and devitrification, caused by large crystals or phase separation in the glass ceramic or microcrystalline glass.

In the present application, devitrification refers to a state where the glass ceramic/microcrystalline glass completely loses its transparent characteristics due to large crystals or phase separation, making it impossible to see any image on the opposite side through the glass.

In the present application, surface CS refers to a surface compressive stress or surface compression stress. After the glass ceramic/microcrystalline glass is chemically strengthened, the alkali metal ions having a smaller surface radius are replaced by those alkali metal ions having a larger radius. Due to the "crowding" effect of the alkali metal ions having a larger radius, a compressive stress thus generated on the glass surface, which is known as surface compressive stress.

In the present application, |CT_CV| refers to an absolute value of the maximum tensile stress in the tensile stress layer, and specifically refers to the absolute value of the maximum value of all tensile stress in the tensile stress layer.

In the present application, CS_50 refers to a compressive stress value at a depth of 50 $\mu$m from the glass surface.

In the present application, DOL_0 refers to a depth of the compression stress layer, also known as the depth of the compressive stress layer, and refers to a distance from any surface of the glass to a position close to that surface where the compressive stress is zero.

In the present application, |CT_AV| refers to an absolute value of the average tensile stress in the tensile stress layer, and specifically refers to the absolute value of the average value of all tensile stress in the tensile stress layer.

In the present application, CT_LD refers to a tensile stress linear density, which is the ratio of an absolute value of the sum of the tensile stress of the strengthened glass ceramic measured by a SLP-2000 stress meter to the thickness of the glass. When the glass ceramic is placed in a salt bath for ion exchange, a compressive stress layer (i.e., a strengthened layer) is formed, and a tensile stress layer is formed within the glass during the ion exchange process. The tensile stress layer has an upper boundary separated by a certain distance from the upper surface of the strengthened glass ceramic and a lower boundary separated by a certain distance from the lower surface of the strengthened glass ceramic. Taking the value of the tensile stress at a point on a line segment within the tensile stress layer which is simultaneously perpendicular to both the upper and lower boundaries and has its upper and lower endpoints falling on the upper and lower boundaries respectively, as the Y-axis, and the distance of the corresponding point from the upper boundary as the X-axis, a tensile stress profile is defined. The ratio of the definite integral of the tensile stress profile to the thickness of the strengthened glass ceramic is defined as the tensile stress linear density.

In the present application, SOC refers to a stress optical coefficient. Photoelasticity mainly refers to the property of some transparent materials, while under stress, to become anisotropic and double refracting. Through the measurement of stress optical coefficient and double refracting, the value of internal residual stress (MPa) of the material can be obtained.

In the present application, the surface $K_2O$ concentration is equal to the mass of $K_2O$ divided by the total mass of oxides, wherein the total mass of oxides comprises $SiO_2$, $Al_2O_3$, $P_2O_5$, $ZrO_2$, $Na_2O$, $K_2O$, and other oxides that can be accurately tested by XRF, and does not comprise $Li_2O$, $B_2O_3$, and the like that cannot be accurately tested by XRF. The XRF test is performed using a standardless test, and the mass of elements with atomic numbers 6 or less or oxides thereof in the glass is not tested. That is, in the present application, when calculating the $K_2O$ concentration obtained by XRF test, the total mass of oxides does not comprise the mass of elements with atomic numbers 6 or less or oxides thereof in the glass.

In the present application, Vickers hardness refers to the standard for representing the hardness of a material proposed by Robert L. Smith and George E. Sandland of Britain at Vickers Ltd in 1921.

In the present application, fracture toughness refers to the resistance value exhibited by a material, in the case of cracks or crack-like defects in a specimen or component, when a rapid fracture that no longer changes with the increase of load occurs starting from the cracks or crack-like defects, i.e., when the so-called unstable fracture occurs.

In a first aspect, in a specific embodiment of the present application, the lithium-free transparent spinel glass ceramic is prepared from a base glass by heat treatment. The present application provides a lithium-free transparent spinel glass ceramic, wherein the lithium-free transparent spinel glass ceramic comprises a spinel crystal, and the spinel crystal is the main crystalline phase of the glass ceramic.

The composition of the lithium-free transparent spinel glass ceramic comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$ 3.00 to 8.00 mol%, $K_2O$ 0 to 2.00 mol% and $Y_2O_3$ 0 to 1.00 mol%; wherein the lithium-free transparent spinel glass ceramic is substantially free of $Li_2O$, with less than 0.01% $Li_2O$ in mol%.

In the following, the ranges of the components (ingredients) of the lithium-free transparent spinel glass ceramic of the present application are described.

The inventors found that in the formulation system of the present application, a proper increase of $Na_2O$ content is helpful to obtain higher stress characteristics of the glass ceramic in chemical strengthening, including high surface stress characteristics and high deep-layer stress characteristics, and at the same time reduce melting temperature and the temperature of crystal precipitation. When the $Na_2O$ content is too low, it is not only unfavorable for the glass ceramic to obtain high stress characteristics through strengthening, but also leads to an increase of heat treatment temperature and increases the difficulty of mass production of the glass ceramic. Besides, during the heat treatment process, it is also easy to cause direct phase separation or precipitation of impurity phase that affects the optical performance of the glass ceramic, resulting in a semi-transparent or even opaque glass ceramic. While excessive addition of $Na_2O$ will affect the network structure of the glass due to providing a large amount of free oxygen, and it is also easy to lead to a ceramization of the base glass during annealing process or to a precipitation of impurity phase(s) that affects the optical performance of the glass ceramic during the heat treatment process of the base glass in the preparation of the glass ceramic, reducing the transmittance of the obtained glass ceramic. Therefore, in the present application, the $Na_2O$ content in mol% is 7.20% to 14.00%, preferably 7.20% to 13.00%, and more preferably 7.20% to 12.00%.

In some embodiments of the present application, the above lithium-free transparent spinel glass ceramic may comprise $Na_2O$ in a molar percentage of 7.20% to 13.50%, 7.20% to 13.00%, 7.20% to 12.50%, 7.20% to 12.00%, 7.20% to 11.50%, 7.20% to 11.00%, 7.20% to 10.50%, 7.20% to 10.00%, 7.20% to 9.50%, 7.20% to 9.00%, 7.70% to 14.00%, 8.20% to 14.00%, 8.70% to 14.00%, 9.20% to 14.00%, 9.70% to 14.00%, 10.20% to 14.00%, 10.70% to 14.00%, or 11.50% to 14.00%. In some embodiments of the present application, the above lithium-free transparent spinel glass ceramic may comprise $Na_2O$ in a molar percentage of 7.20%, 7.70%, 8.20%, 8.70%, 9.20%, 9.70%, 10.20%, 10.70%, 11.20%, 11.50%, 12.20%, 12.70%, 13.20%, 13.70%, or 14.00%, or any value within a numerical range formed of any two of the above specified values as endpoints. It should be understood that in specific embodiments, any of the above ranges may be combined with any other ranges, as long as a glass with a desired property of the present application is obtained.

The inventors found that $SiO_2$ is an oxide formative of the glass network and is an indispensable component of the glass network structure. In the formulation system of the present application, a proper increase in the $SiO_2$ content can increase the stability and mechanical strength of the glass, but excessive $SiO_2$ will increase the viscosity of the base glass, making it more difficult to melt the glass, thereby reducing the formability of the base glass. Therefore, in the present application, the $SiO_2$ content in mol% is 38.00% to 48.00%, preferably 38.00% to 44.00%.

In some embodiments of the present application, the above lithium-free transparent spinel glass ceramic may comprise $SiO_2$ in a molar percentage of 38.00% to 48.00%, 38.50% to 48.00%, 39.00% to 48.00%, 40.00% to 48.00%, 42.00% to 48.00%, 44.00% to 48.00%, 38.00% to 46.00%, 38.00% to 44.00%, 38.00% to 42.00%, or 38.00% to 40.00%. In some embodiments of the present application, the above lithium-free transparent spinel glass ceramic may comprise $SiO_2$ in a molar percentage of 38.00%, 38.50%, 39.00%, 40.00%, 41.00%, 42.00%, 43.00%, 44.00%, 45.00%, 46.00%, 47.00% or 48.00%, or any value within a numerical range formed of any two of the above specified values as endpoints. It should be understood that in specific embodiments, any of the above ranges may be combined with any other ranges, as long as a glass with a desired property of the present application is obtained.

The inventors found that in the formulation system of the present application, proper addition of $Al_2O_3$ can not only promote the precipitation of the main crystalline phase spinel and inhibit the precipitation of other impurity phases such as quartz solid solution (quartz ss) that affect the optical performance of the glass ceramic of this system, but also increase the ion exchange rate in the strengthening process and promote the ion exchange. However, excessive $Al_2O_3$ will lead to a rapid increase in the difficulty of melting the base glass, and at the same time accelerate the crystallization rate of the base glass, so that the base glass will be prone to crystallization and devitrification during the normal cooling in preparation process. Therefore, in the present application, the $Al_2O_3$ content in mol% is 25.50% to 30.00%, preferably 25.50% to 28.00%.

In some embodiments of the present application, the above lithium-free transparent spinel glass ceramic may comprise $Al_2O_3$ in a molar percentage of 25.50% to 29.50%, 25.50% to 29.00%, 25.50% to 28.50%, 25.50% to 28.00%, 25.50% to 27.50%, 25.50% to 27.00%, 25.50% to 26.50%, 26.00% to 30.00%, 26.50% to 30.00%, 27.00% to 30.00%, 27.50% to 30.00%, 28.00% to 30.00%, 28.50% to 30.00%, or 29.00% to 30.00%. In some embodiments of the present application, the above lithium-free transparent spinel glass ceramic may comprise $Al_2O_3$ having a molar percentage of 25.50%, 26.00%, 26.50%, 27.00%, 27.50%, 28.00%, 28.50%, 29.00%, 29.50%, or 30.00%, or any value within a numerical range formed of any two of the above specified values as endpoints. It should be understood that in specific embodiments, any of the above ranges may be combined with any other ranges, as long as a glass with a desired property of the present application is obtained.

The inventors found that in the formulation system of the present application, MgO and ZnO, as the main components of spinel, can promote the precipitation of spinel and reduce the melting difficulty of the base glass to a certain extent when added in a proper amount. However, an excessive addition of MgO and ZnO usually leads to an extremely easy growth of the spinel grains, and it is very difficult to obtain a glass ceramic with a high transparency. That is, the relationship between the MgO content and the ZnO content largely determines whether the glass ceramic sample can be transparent and whether or not has an excellent optical performance. Therefore, in the present application, the MgO content in mol% is 5.00% to 8.00%, preferably 5.00% to 7.00%, and more preferably 5.00% to 6.50%; the ZnO content in mol% is 8.00% to 14.00%, preferably 8.00% to 12.00%, and more preferably 8.00% to 10.50%.

In some embodiments of the present application, the above lithium-free transparent spinel glass ceramic may comprise MgO in a molar percentage of 5.50% to 8.00%, 6.00% to 8.00%, 6.50% to 8.00%, 7.00% to 8.00%, 5.00% to 7.50%, 5.00% to 7.00%, 5.00% to 6.50%, or 5.00% to 6.00%. In some embodiments of the present application, the above lithium-free transparent spinel glass ceramic may comprise MgO in a molar percentage of 5.00%, 5.50%, 6.00%, 6.50%, 7.00%, 7.50%, or 8.00%, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the above lithium-free transparent spinel glass ceramic may comprise ZnO in a molar percentage of 8.50% to 14.00%, 9.00% to 14.00%, 9.50% to 14.00%, 10.00% to 14.00%, 10.50% to 14.00%, 11.00% to 14.00%, 11.50% to 14.00%, 12.00% to 14.00%, 8.00% to 13.50%, 8.00% to 13.00%, 8.00% to 12.50%, 8.00% to 12.00%, 8.00% to 11.50%, 8.00% to 11.00%, 8.00% to 10.50%, or 8.00% to 10.00%. In some embodiments of the present application, the above lithium-free transparent spinel glass ceramic may comprise ZnO in a molar percentage of 8.00%, 8.50%, 9.00%, 9.50%, 10.00%, 10.50%, 11.00%, 11.50%, 12.00%, 12.50%, 13.00%, 13.50%, or 14.00%, or any value within a numerical range formed of any two of the above specified values as endpoints. It should be understood that in specific embodiments, any of the above ranges may be combined with any other ranges, as long as a glass with a desired property of the present application is obtained.

The inventors found that in the formulation system of the present application, as an effective nucleating agent, $ZrO_2$ firstly precipitates out of the glass in the form of crystals during the heat treatment of the base glass in the preparation of the glass ceramic, and the $ZrO_2$ crystals become crystal nucleus for the subsequent growth of the main crystal spinel. In a certain range of glass composition, the content of $ZrO_2$ will affect the formation of the base glass and the crystal shape, crystal type and crystal size of the glass ceramic after heat treatment of the base glass. Therefore, in the present application, the $ZrO_2$ content in mol% is 3.00% to 5.00%, preferably 3.00% to 4.00%.

In some embodiments of the present application, the above lithium-free transparent spinel glass ceramic may comprise $ZrO_2$ in a molar percentage of 3.50% to 5.00%, 4.00% to 5.00%, 4.50% to 5.00%, 3.00% to 4.50%, 3.00% to 4.00%, or 3.00% to 3.50%. In some embodiments of the present application, the above lithium-free transparent spinel glass ceramic may comprise $ZrO_2$ in a molar percentage of 3.00%, 3.50%, 4.00%, 4.50%, or 5.00%, or any value within a numerical range formed of any two of the above specified values as endpoints. It should be understood that in specific embodiments, any of the above ranges may be combined with any other ranges, as long as a glass with a desired property of the present application is obtained.

The inventors found that in the formulation system of the present application, a proper amount of $B_2O_3$ can not only significantly reduce the difficulty of melting the base glass, but also promote the precipitation of the main crystalline phase spinel. When $B_2O_3$ is added in an insufficient amount, it is easy to lead to melting defects in the preparation of base glass. However, excessive addition of $B_2O_3$ is easy to lead to opacification of the glass during heat treatment of the base glass in the preparation of the glass ceramic, and may also lead to the precipitation of other impurity crystalline phase(s), severely affecting the transparency of the glass ceramic. Therefore, in the present application, the $B_2O_3$ content in mol% is 3.00% to 8.00%, preferably 3.00% to 7.00%, and more preferably 3.00% to 6.50%.

In some embodiments of the present application, the above lithium-free transparent spinel glass ceramic may comprise $B_2O_3$ in a molar percentage of 3.50% to 8.00%, 4.00% to 8.00%, 4.50% to 8.00%, 5.00% to 8.00%, 5.50% to 8.00%, 6.00% to 8.00%, 6.50% to 8.00%, 7.00% to 8.00%, 3.00% to 7.50%, 3.00% to 7.00%, 3.00% to 6.50%, 3.00% to 6.00%, 3.00% to 5.50%, 3.00% to 5.00%, 3.00% to 4.50% or 3.00% to 4.00%. In some embodiments of the present application, the above lithium-free transparent spinel glass ceramic may comprise $B_2O_3$ in a molar percentage of 3.00%, 3.50%, 4.00%, 4.50%, 5.00%, 5.50%, 6.00%, 6.50%, 7.00%, 7.50%, or 8.00%, or any value within a numerical range formed of any two of the above specified values as endpoints. It should be understood that in specific embodiments, any of the above ranges may be combined with any other ranges, as long as a glass with a desired property of the present application is obtained.

In order to ensure the melting performance and optical performance of the glass, in the present application, $Na_2O+B_2O_3$ is 10.20% to 20.00%, preferably 10.20% to 18.00%. The coordination of $Na_2O+B_2O_3$ with the whole composition can solve the melting problem and at the same time make the base glass to obtain a better optical performance, and the increase of $Na_2O$ and $B_2O_3$ can synergistically solve the melting problem caused by the increase of $Al_2O_3$ content.

The inventors found that in the formulation system of the present application, although BaO can improve the melting performance of the base glass and inhibit the growth of crystal grains to a certain extent, so as to have a certain improvement in the optical performance of the glass ceramic, but it also has a strong inhibitory effect on Na-K exchange, which is not conducive to the chemical strengthening of the glass ceramic. Therefore, in the present application, BaO is preferably not added, and has an amount of less than 0.01% in mol%.

The inventors found that in the formulation system of the present application, the addition of $TiO_2$ as a nucleating agent induces undesired coloration in the base glass. To obtain the desired transparent and colorless glass ceramic, the present application is preferably free of $TiO_2$, with less than 0.01% $TiO_2$ in mol%.

The inventors found that in the formulation system of the present application, $K_2O$ is an optional component that helps to improve the low temperature melting property and formability of the glass. Since the radius of $K^+$ is larger than that of $Na^+$, a proper addition of $K_2O$ can reduce the crystallization tendency of the glass while increasing the transparency and gloss. However, too much $K_2O$ not only reduces the chemical stability and hardness of the glass, but also increases the crystallization ability of the glass, making it susceptible to devitrification, and is easy to break after crystallization. Therefore, in the present application, the $K_2O$ content in mol% is 0.00% to 2.00%.

The inventors found that in the formulation system of the present application, $Y_2O_3$ is an optional component for improving the hardness and chemical stability of the glass ceramic and inhibiting the crystallization during glass molding. A proper amount of $Y_2O_3$ can enhance the denseness of the glass phase, thereby enhancing the overall strength of the glass ceramic. At the same time, $Y_2O_3$ can form a eutectic with $ZrO_2$, which reduces the unevenness caused by the precipitation of $ZrO_2$ when melting in a furnace. However, excess amount of $Y_2O_3$ will affect the precipitation of spinel crystals and reduce the chemical strengthening properties of the glass ceramic. Therefore, in the present application, the $Y_2O_3$ content in mol% ranges from 0 to 1.00%.

In some embodiments of the present application, in molar percentage of each oxide in the composition of the lithium-free transparent spinel glass ceramic, the lithium-free transparent spinel glass ceramic of the present application satisfies:

for an A-value calculated based on the following formula (1), the A-value is less than or equal to 0.18, and preferably the A-value is 0.05 to 0.15,

$$(1)\ A=0.65\times Al_2O_3+3.5\times ZrO_2-0.8\times Na_2O-2.5\times B_2O_3;$$

and/or,
for a B-value calculated based on the following formula (2), the B-value is less than or equal to 0.80, and preferably the B-value is 0.60 to 0.78,

$$(2)\ B=3.8\times Na_2O+B_2O_3+4.5\times MgO+6.0\times ZnO-0.4\times Al_2O_3-SiO_2.$$

Through experimental research, the inventors found that the A-value calculated based on the above formula is closely related to the melting performance of the base glass used in the preparation of the lithium-free transparent spinel glass ceramic. By modifying the specific proportional relationships of the above oxide components, controlling the A-value within a proper range ensures that a transparent base glass is obtained that meets the requirements and that each oxide component in the base glass can be completely melted without any unmelted components.

Through experimental research, the inventors also found that the B-value calculated based on the above formula is also closely related to the melting performance of the base glass used in the preparation of the lithium-free transparent spinel glass ceramic. By modifying the specific proportional relationships of the above oxide components, controlling the B-value within a proper range ensures that the base glass will not undergo ceramization during its preparation process, particularly during the annealing process, and thereby ensures that the transparent base glass that meets the requirements is obtained.

In some embodiments of the present application, the A-value may be 0.07 to 0.15, 0.09 to 0.15, 0.11 to 0.15, 0.13 to 0.15, 0.05 to 0.13, 0.05 to 0.11, 0.05 to 0.09, or 0.05 to 0.07. In some embodiments of the present application, the above lithium-free transparent spinel glass ceramic may comprise an A-value of 0.05, 0.07, 0.09, 0.11, 0.13, 0.15, 0.17 or 0.18, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the B-value may be 0.60 to 0.76, 0.60 to 0.74, 0.60 to 0.72, 0.60 to 0.70, 0.60 to 0.68, 0.60 to 0.66, 0.60 to 0.64, 0.62 to 0.78, 0.64 to 0.78, 0.66 to 0.78, 0.68 to 0.78, 0.70 to 0.78, 0.72 to 0.78, or 0.74 to 0.78. In some embodiments of the present application, the above lithium-free transparent spinel glass ceramic may comprise a B-value of 0.60, 0.62, 0.64, 0.66, 0.68, 0.70, 0.72, 0.74, 0.76, 0.78, or 0.80, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, in the lithium-free transparent spinel glass ceramic, the molar percentage of each of components $Al_2O_3$, MgO and ZnO satisfies the following relationship: the molar percentage of $Al_2O$ minus the molar percentage of MgO and the molar percentage of ZnO is 8.00 to 15.00%, i.e., $Al_2O_3$-MgO-ZnO = 8.00 to 15.00 mol%. $Al_2O_3$, MgO and ZnO are all major components of the spinel crystal, the main crystalline phase in the present application. By adjusting the relationship among the contents of $Al_2O_3$, MgO, and ZnO, the present application can, on the one hand, can ensure that a glass ceramic with a high crystalline content/crystallinity can be obtained, which is conducive to improving the intrinsic strength of the glass ceramic; on the other hand, making a proper amount of $Al_2O_3$ remaining in the residual glass phase to form an $[AlO_4]$ tetrahedral structure is also more conducive to achieving the chemical strengthening of the glass ceramic, and is conducive to strengthening the glass ceramic to obtain high stress characteristics. That's because the volume of the $[AlO_4]$ tetrahedra is larger than that of $[SiO_4]$, and the presence of a proper amount of $[AlO_4]$ is more conducive to broadening the ion exchange channels and promoting the diffusion of alkali metal ions.

In some embodiments of the present application, the value of $Al_2O_3$-MgO-ZnO may be 8.50 to 15.00%, 9.00 to 15.00%, 9.50 to 15.00%, 10.00 to 15.00%, 10.50 to 15%, 11.00 to 15.00%, 11.50 to 15.00%, 12.00 to 15.00%, 12.50 to 15%, 13.00 to 15.00%, 13.50 to 15.00%, 14.00 to 15.00%, 8.00 to 14.50%, 8.00 to 14.00%, 8.00 to 13.50%, 8.00 to 13.00%, 8.00 to 12.50%, 8.00 to 12.00%, 8.00 to 11.50%, 8.00 to 11.00%, 8.00 to 10.50%, 8.00 to 10.00%, 8.00 to 9.50%, or 8.00 to 9.00%. In some embodiments of the present application, the above lithium-free transparent spinel glass ceramic may comprise $Al_2O_3$-MgO-ZnO in an amount of 8.00%, 8.50%, 9.00%, 9.50%, 10.00%, 10.50%, 11.00%, 11.50%, 12.00%, 12.50%, 13.00%, 13.50%, 14.00%, 14.50% or 15.00%, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, in molar percentage of each oxide in the lithium-free transparent spinel glass ceramic, the composition of the lithium-free transparent spinel glass ceramic of the present application satisfies:

for an X-value calculated based on the following formula (3), the X-value is 30.00 to 50.00%, and preferably the X-value is 34.00 to 46.00%,

$$(3)\ X=2.1\times(Al_2O_3\text{-}MgO\text{-}ZnO)/(SiO_2+Al_2O_3\text{-}MgO\text{-}ZnO+Na_2O+K_2O+B_2O_3);$$

and/or,

for a Y-value calculated based on the following formula (4), the Y-value is 60.00 to 80.00%, and preferably the Y-value is 60.00 to 75.00%,

$$(4)\ Y=(2.7\times Na_2O+1.8\times(Al_2O_3\text{-}MgO\text{-}ZnO))/(SiO_2+Al_2O_3\text{-}MgO\text{-}ZnO+Na_2O+K_2O+B_2O_3).$$

Through experimental research, the inventors found that the X-value calculated based on the above formula is closely related to the deep-layer stress characteristics that can be obtained after chemical strengthening of the lithium-free transparent spinel glass ceramic. By modifying the specific proportional relationships of the above oxide components, controlling the X-value in a proper range can ensure excellent deep-layer stress characteristics of the glass ceramic after chemical strengthening, such as high CS_50, DOL_O, |CT_AV|, |CT_CV|, and CT_LD values.

Through experimental research, the inventors also found that the Y-value calculated based on the above formula is closely related to the surface stress characteristics that can be obtained after chemical strengthening of the lithium-free transparent spinel glass ceramic. By modifying the specific proportional relationships of the above oxide components, controlling the Y-value in a proper range can ensure excellent surface stress characteristics of the glass ceramic after chemical strengthening, such as high surface $K_2O$ concentration and high surface CS value.

In some embodiments of the present application, the X-value may be 32.00 to 50.00%, 34.00 to 50.00%, 36.00 to 50.00%, 38.00 to 50.00%, 40.00 to 50.00%, 42.00 to 50.00%, 44.00 to 50.00%, 46.00 to 50.00%, 30.00 to 48.00%, 30.00 to 46.00%, 30.00 to 44.00%, 30.00 to 42.00%, 30.00 to 40.00%, 30.00 to 38.00%, 30.00 to 36.00% or 30.00 to 34.00%. In some embodiments of the present application, the above lithium-free transparent spinel glass ceramic may comprise an X-value of 30.00%, 32.00%, 34.00%, 36.00%, 38.00%, 40.00%, 42.00%, 44.00%, 46.00%, 48.00%, or 50.00%, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the Y-value may be 62.00 to 80.00%, 64.00 to 80.00%, 66.00 to 80.00%, 68.00 to 80.00%, 70.00 to 80.00%, 72.00 to 80.00%. 74.00 to 80.00%, 76.00 to 80.00%, 60.00 to 78.00%, 60.00 to 76.00%, 60.00 to 74.00%, 60.00 to 72.00%, 60.00 to 70.00%, 60.00 to 68.00%, 60.00 to 66.00% or 60.00 to 64.00%. In some embodiments of the present application, the above lithium-free transparent spinel glass ceramic may comprise a Y-value of 60.00%, 62.00%, 64.00%, 66.00%, 68.00%, 70.00%, 72.00%, 74.00%, 76.00%, 78.00%, or 80.00%, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the spinel crystal of the present application is zinc-magnesium spinel solid solution $(Zn, Mg)Al_2O_4$, i.e., the main crystalline phase of the lithium-free transparent spinel glass ceramic of the present application is $(Zn, Mg)Al_2O_4$; and/or, the lithium-free transparent spinel glass ceramic of the present application further comprises tetragonal zirconia as a secondary crystalline phase. $(Zn, Mg)Al_2O_4$ has high Young modulus and shear modulus, which is beneficial to improve the intrinsic strength of the glass ceramic and glass ceramic products of the present application, e.g., to make the glass ceramic and glass ceramic products exhibit high hardness, strength, fracture toughness, and the like.

In some embodiments of the invention, the lithium-free transparent spinel glass ceramic of the present application have a good crystallinity, for example, the crystallinity of the lithium-free transparent spinel glass ceramic is above 20 wt.%; preferably, the crystallinity is 20.00 to 50.00 wt.%; further preferably, the crystallinity is 30.00 to 50.00 wt.%; and more preferably, the crystallinity is 35.00 to 45.00 wt.%. High crystallinity/crystal content can endow the glass ceramic with a higher intrinsic strength, so that the glass ceramic and glass ceramic products of the present application have excellent mechanical performance.

In some embodiments of the present application, the crystallinity of the lithium-free transparent spinel glass ceramic can be 22.00 to 50.00 wt.%, 24.00 to 50.00 wt.%, 26.00 to 50.00 wt.%, 28.00 to 50.00 wt.%, 30.00 to 50.00 wt.%,

32.00 to 50.00 wt.%, 34.00 to 50.00 wt.%, 36.00 to 50.00 wt.%, 38.00 to 50.00 wt.%, 40.00 to 50.00 wt.%, 42.00 to 50.00 wt.%, 44.00 to 50.00 wt.%, 46.00 to 50.00 wt.%, 20.00 to 48.00 wt.%, 20.00 to 46.00 wt.%, 20.00 to 44.00 wt.%, 20.00 to 42.00 wt.%, 20.00 to 40.00 wt.%, 20.00 to 38.00 wt.%, 20.00 to 36.00 wt.%, 20.00 to 34.00 wt.%, 20.00 to 32.00 wt.%, 20.00 to 30.00 wt.%, 20.00 to 28.00 wt.%, 20.00 to 26.00 wt.% or 20.00 to 24.00 wt.%. In some embodiments of the present application, the above lithium-free transparent spinel glass ceramic (also referred to as glass ceramic for chemical strengthening) may has a crystallinity of 20.00 wt.%, 22.00 wt.%, 24.00 wt.%, 26.00 wt.%, 28.00 wt.%, 30.00 wt.%, 32.00 wt.%, 34.00 wt.%, 35.00 wt.%, 36.00 wt.%, 38.00 wt.%, 40.00 wt.%, 42.00 wt.%, 44.00 wt.%, 45.00 wt.%, 46.00 wt.%, 48.00 wt.% or 50.00 wt.%, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, in the lithium-free transparent spinel glass ceramic of the present application, the average grain size is $\leq 15.0$ nm, preferably 1.0 to 15.0 nm, further preferably 1.0 to 10.0 nm, more preferably 4.5 to 8.0 nm. Proper grain size is beneficial to make glass ceramic achieve excellent optical performances.

In some embodiments of the present application, the average grain size of the lithium-free transparent spinel glass ceramic of the present application can be 1.0 to 13.0 nm, 1.0 to 11.0 nm, 1.0 to 9.0 nm, 1.0 to 7.0 nm, 1.0 to 5.0 nm, 1.0 to 3.0 nm, 3.0 to 15.0 nm, 3.0 to 13.0 nm, 3.0 to 11.0 nm, 3.0 to 9.0 nm, 3.0 to 7.0 nm or 3.0 to 5.0 nm. In some embodiments of the present application, the above lithium-free transparent spinel glass ceramic may comprise an average grain size of 1.0 nm, 3.0 nm, 4.5 nm, 5.0 nm, 7.0 nm, 8.0 nm, 9.0 nm, 10.0 nm, 11.0 nm, 13.0 nm or 15.0 nm, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the lithium-free transparent spinel glass ceramic of the present application exhibits a high transparency in the visible light range (i.e., the lithium-free transparent spinel glass ceramic is transparent). The lithium-free transparent spinel glass ceramic of the present application exhibits a high transmittance in the visible light range, for example, for light at a wavelength of 550 nm, the transmittance of the lithium-free transparent spinel glass ceramic with a thickness of 0.7 mm is greater than or equal to 85%, preferably greater than or equal to 89%.

In some embodiments of the present application, for light at a wavelength of 550 nm, the transmittance of the lithium-free transparent spinel glass ceramic with a thickness of 0.7 mm can be 89.0%, 89.5%, 90.0%, 90.5% or 91.0%, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the Young modulus of the lithium-free transparent spinel glass ceramic is $\geq 100$ GPa, preferably, the Young modulus is $\geq 110$ GPa, and more preferably 114 GPa $\leq$ Young modulus $\leq 140$ GPa.

In some embodiments of the present application, the Young modulus of the lithium-free transparent spinel glass ceramic can be 114 to 138 GPa, 114 to 136 GPa, 114 to 134 GPa, 114 to 132 GPa, 114 to 130 GPa, 114 to 128 GPa, 114 to 126 GPa, 116 to 140 GPa, 118 to 140 GPa, 120 to 140 GPa, 122 to 140 GPa, 124 to 140 GPa, 126 to 140 GPa or 128 to 140 GPa. In some embodiments of the present application, the Young modulus of the above lithium-free transparent spinel glass ceramic can be 100 GPa, 114 GPa, 116 GPa, 118 GPa, 120 GPa, 122 GPa, 124 GPa, 126 GPa, 128 GPa, 130 GPa, 135 GPa or 140 GPa, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the optical b-value of the lithium-free transparent spinel glass ceramic with a thickness of 0.7 mm is 0.20 to 1.50, preferably 0.50 to 1.20.

In some embodiments of the present application, the optical b-value of the lithium-free transparent spinel glass ceramic with a thickness of 0.7 mm can be 0.20 to 1.40, 0.20 to 1.30, 0.20 to 1.20, 0.20 to 1.10, 0.20 to 1.00, 0.20 to 0.90, 0.20 to 0.80, 0.20 to 0.70, 0.20 to 0.60, 0.30 to 1.50, 0.40 to 1.50, 0.50 to 1.50, 0.60 to 1.50, 0.70 to 1.50, 0.80 to 1.50, 0.90 to 1.50, 1.00 to 1.50 or 1.10 to 1.50. In some embodiments of the present application, the optical b-value of the lithium-free transparent spinel glass ceramic can be 0.20, 0.30, 0.40, 0.50, 0.60, 0.70, 0.80, 0.90, 1.00, 1.10, 1.20, 1.30, 1.40 or 1.50, or any value within a numerical range formed of any two of the above specified values as endpoints. It should be understood that in specific embodiments, any of the above ranges may be combined with any other ranges, as long as a glass with a desired property of the present application is obtained.

In a second aspect, the lithium-free transparent spinel glass ceramic of the present application can be produced and manufactured by the following method: subjecting a base glass to a heat treatment to form the lithium-free transparent spinel glass ceramic; the lithium-free transparent spinel glass ceramic comprises a spinel crystal, and the spinel crystal is the main crystalline phase of the lithium-free transparent spinel glass ceramic; the composition of the lithium-free transparent spinel glass ceramic comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$

3.00 to 8.00 mol%, $K_2O$ 0 to 2.00 mol% and $Y_2O_3$ 0 to 1.00 mol%; wherein the lithium-free transparent spinel glass ceramic is substantially free of $Li_2O$, with less than 0.01% $Li_2O$ in mol%.

Exemplarily, the preparation method of the lithium-free transparent spinel glass ceramic of the present application may comprise the steps of:

(1) preparing a base glass: the base glass comprises the following oxides in mol%: $SiO_2$ 38.00 to 48.00 mol%, $Al_2O_3$ 25.50 to 30.00 mol%, $ZrO_2$ 3.00 to 5.00 mol%, MgO 5.00 to 8.00 mol%, ZnO 8.00 to 14.00 mol%, $Na_2O$ 7.20 to 14.00 mol%, $B_2O_3$ 3.00 to 8.00 mol%, $K_2O$ 0 to 2.00 mol% and $Y_2O_3$ 0 to 1.00 mol%; wherein the base glass is substantially free of $Li_2O$, with less than 0.01% $Li_2O$ in mol%; and
(2) preparing the lithium-free transparent spinel glass ceramic: subjecting the base glass obtained in step (1) to a heat treatment to obtain the lithium-free transparent spinel glass ceramic.

It should be understood that, in mol% of the oxides, the composition of the base glass is the same as that of the lithium-free transparent spinel glass ceramic of the present application.

The heat treatment in step (2) may comprise a nucleation treatment and/or a crystallization treatment, that is, when subjecting the base glass to the heat treatment, a single-step heat treatment or a two or more-steps heat treatment may be performed. If a single-step heat treatment is performed, the nucleation treatment is not separately conducted, but the nucleation and target crystal growth are conducted in a single heating process, which can be understood as directly conducting the crystallization treatment. When a two-step heat treatment is performed, two heating steps are carried out in which a nucleus formation is carried out first, i.e., a nucleation treatment, followed by a target crystal growth treatment, i.e., a crystallization treatment.

It should be understood that in the present application, the nucleation treatment is carried out by raising the temperature to a specified nucleation treatment temperature (also called nucleation temperature), and after reaching the nucleation treatment temperature, keeping the temperature for a certain time (that is, nucleation treatment time, also called nucleation time). The crystallization treatment is carried out by raising the temperature to a specified crystallization treatment temperature (also called crystallization temperature), and after reaching the crystallization treatment temperature, keeping the temperature for a certain time (that is, crystallization treatment time, also called crystallization time).

To precipitate the desired crystal phase of the lithium-free transparent spinel glass ceramic and obtain the desired physicochemical properties, preferably the heat treatment process of the present application is as follows: the nucleation treatment temperature is 600 °C to 850 °C, and the nucleation treatment time can be 0 to 72 hours, preferably 0 to 24 hours; the crystallization treatment temperature is 700 °C to 1000 °C, and the crystallization treatment time is 0.1 to 72 hours, preferably 0.1 to 24 hours.

It is worth mentioning that through experimental research, the inventors found that the desired target glass ceramic can be prepared at a heat treatment temperature lower than that of the existing schemes because the formulation of the present application is optimized. Therefore, in the present application, the nucleation treatment temperature is preferably 600 C to 750 °C, and the crystallization treatment temperature is preferably 700 °C to 800 °C, which are more conducive to improving the manufacturability of glass ceramic and more in line with the development requirements of energy efficiency and carbon reduction in the industry.

In some embodiments of the present application, the lithium-free transparent spinel glass ceramic is prepared by a two-step heating treatment, that is, the glass ceramic is prepared by performing a nucleation treatment followed by a crystallization treatment in sequence on the base glass. In some embodiments of the present application, when the nucleation treatment temperature is 600 °C to 750 °C, the nucleation treatment time is preferably 60 to 360 minutes, more preferably, the nucleation treatment time is 100 to 300 minutes; and/or, when the crystallization treatment temperature is 700 °C to 800 °C, the crystallization treatment time is preferably 60 to 360 minutes, more preferably, the crystallization treatment time is 100 to 300 minutes.

In some embodiments of the present application, during the heat treatment, the heating rate is controlled to be 5 to 15 K/min, and preferably the heating rate is 10 K/min. It should be understood that the heating rate herein comprises the heating rate from room temperature to the nucleation temperature, and also comprises the heating rate from the nucleation temperature to the crystallization temperature.

In some embodiments of the present application, in molar percentage of each oxide in the base glass, the composition of the base glass of the present application satisfies:

$$A = 0.65 \times Al_2O_3 + 3.5 \times ZrO_2 - 0.8 \times Na_2O - 2.5 \times B_2O_3,$$

wherein $A \leq 0.18$, and preferably the A-value is 0.05 to 0.15;

and/or, $B = 3.8 \times Na_2O + B_2O_3 + 4.5 \times MgO + 6.0 \times ZnO - 0.4 \times Al_2O_3 - SiO_2$, wherein $B \leq 0.80$, and preferably the B-value is 0.60 to 0.78;

and/or, X=2.1×(Al$_2$O$_3$-MgO-ZnO)/(SiO$_2$+Al$_2$O$_3$-MgO-ZnO+Na$_2$O+K$_2$O+B$_2$O$_3$), wherein X=30.00 to 50.00%, and preferably X=34.00 to 46.00%;
and/or, Y=(2.7 ×Na$_2$O+1.8×(Al$_2$O$_3$-MgO-ZnO))/(SiO$_2$+Al$_2$O$_3$-MgO-ZnO+Na$_2$O+K$_2$O+B$_2$O$_3$), wherein Y= 60.00 to 80.00%, and preferably Y=60.00 to 75.00%;
and/or, in the base glass, the molar percentage of each of components Al$_2$O$_3$, MgO and ZnO satisfies the following relationship: Al$_2$O$_3$-MgO-ZnO=8.00 to 15.00%.

In some embodiments of the present application, the base glass of the present application is substantially free of BaO, with less than 0.01% BaO in mol%; and/or, the base glass is substantially free of TiO$_2$, and with less than 0.01% TiO$_2$ in mol%.

In the present application, the lithium-free transparent spinel glass ceramic obtained in the above step (2) can be subjected to a cold processing treatment as required. The cold processing treatment refers to processing the glass ceramic into glass ceramic samples, for example, processing the glass ceramic into a polished sheet with a desired size, for example a polished sheet with a length, width and thickness of 50 mm×50 mm×0.7 mm, by one or more methods of slicing, grinding and polishing.

In the present application, those skilled in the art can select the thickness of the lithium-free transparent spinel glass ceramic as required; for example, the thickness of the lithium-free transparent spinel glass ceramic is 0.2 to 5.0 mm.

In the present application, the molding methods include but are not limited to float, overflow, calendering and casting. Exemplarily, the components are evenly mixed according to the formulation, and the base glass can be obtained by melt molding, cooling, and annealing processes. Preferably, the mixed raw materials are placed in an electric furnace or gas furnace for melt treatment at a melting temperature of 1250 °C to 1650 °C, more preferably at a melting temperature of 1480 °C to 1650 °C, for a melting time of 5 to 24 hours. After the melting treatment is completed, the liquid glass is poured into a mold for molding, then cooled down to 850 °C to 1000 °C, and then, preferably, placed in an annealing furnace for an annealing treatment at an annealing temperature of 500 °C to 650 °C, and during annealing the temperature is held for 12 to 48 hours.

In the present application, in the preparation of the base glass, a clarifying agent may be added to the raw materials. The clarifying agent comprises, but is not limited to, one or two or more of NaCl, Na$_2$SO$_4$, SnO$_2$, As$_2$O$_3$, Sb$_2$O$_3$, NaNO$_3$, KNO$_3$, CeO$_2$ and (NH$_4$)$_2$SO$_4$; preferably, one or two or more of NaCl, SnO$_2$, NaNO$_3$ and CeO$_2$. Based on the total mass of the raw materials of the base glass, the amount of the clarifying agent added is 0.01 wt.% to 2.00 wt.%, preferably 0.01 wt.% to 1.50 wt.%.

In a third aspect, the present application also provides a chemically strengthened glass. The chemically strengthened glass is obtained by subjecting the above lithium-free transparent spinel glass ceramic, or a lithium-free transparent spinel glass ceramic prepared by the above preparation method, or the above base glass to chemical strengthening. The above lithium-free transparent spinel glass ceramic is chemically strengthened to obtain the strengthened glass ceramic, and the strengthened glass ceramic comprises a compressive stress layer and a tensile stress layer.

In some embodiments of the present application, the above lithium-free transparent spinel glass ceramic may be processed into sheets, and/or shaped (such as punching, hot bending, etc.), polished and/or swept after shaping, and then chemically strengthened by a chemical strengthening process.

The chemical strengthening treatment described in the present application is an ion exchange method. During the ion exchange process, smaller alkali metal ions in the lithium-free transparent spinel glass ceramic are replaced or "exchanged" by larger alkali metal ions having the same valence state close to the glass ceramic. Through the replacement of smaller ions by the larger ions, a compressive stress layer is formed in the glass. The strengthening method of ion exchange can be performed in multiple steps, such as two steps, or in a single step. The ion exchange is carried out by submerging the glass ceramic or the base glass in a salt bath comprising at least one molten salt of larger alkali metal ions, such that the larger alkali metal ions in the salt bath may replace the smaller alkali metal ions in the glass ceramic or the base glass. Besides, other monovalent metal ions such as Ag$^+$, Tl$^+$ and Cu$^+$ and the like can also be used to exchange monovalent ions. The ion exchange process may include, but is not limited to, submerging the subject in a single salt bath, or submerging the subject in a plurality of salt baths having the same or different compositions, with washing and/or annealing steps being arranged between submerging processes.

In some embodiments of the present application, the lithium-free transparent spinel glass ceramic or base glass of the present application can be chemically strengthened by submerging in a salt bath comprising potassium salt(s). In some embodiments of the invention, the temperature of the salt bath for chemical strengthening treatment is 380 °C to 600 °C, preferably 400 °C to 550 °C. Exemplarily, the glass ceramic or the base glass may be submerged in a salt bath comprising molten potassium salts (such as one or more of potassium nitrate, potassium sulfate, and potassium carbonate, preferably potassium nitrate KNO$_3$) at a temperature of about 380 °C to 600 °C for about 4 to 48 hours for ion exchange. Preferably, the temperature of the salt bath for chemical strengthening treatment can be 400 °C to 550 °C, more preferably the temperature of the salt bath is 450 °C to 500 °C; and preferably, the ion exchange/chemical strengthening time is 12 to 48 hours.

In some embodiments of the present application, the concentration of potassium salt(s) in the salt bath for chemical strengthening treatment is 60 wt.% to 100 wt.%. Exemplarily, the composition of a salt bath comprising potassium salts can be 100 wt.% potassium nitrate, or a mixed salt of potassium nitrate and sodium nitrate, and the concentration of potassium nitrate in the mixed salt is greater than or equal to 60 wt.% and less than 100 wt.%. Further, based on the mass of the salt bath, 0 to 1 wt.% $LiNO_3$ can be added to the salt bath as desired.

In the present application, through the chemical strengthening treatment steps, the K ions in the salt bath replace some of the Na ions in the lithium-free transparent spinel glass ceramic, and thus a compressive stress layer is formed at the glass surface and the strengthened glass ceramic is obtained, so that the strengthened glass ceramic achieves a specific stress distribution structure, which gives the strengthened glass ceramic with specific and excellent surface stress characteristics and deep-layer stress characteristics, and thus gives the strengthened glass ceramic with a high mechanical performance.

In some embodiments of the present application, prior to the chemical strengthening treatment, a preheating process of 300 °C to 400 °C may be carried out on the lithium-free transparent spinel glass ceramic as required, with an preferred preheating time of 10 to 30 minutes.

In some embodiments of the present application, a heat migration process of 350 to 500 °C may be carried out between the multiple strengthening steps as required, with a preferred heat migration time of 15 to 120 min.

In some embodiments of the present application, in the single step strengthening or multi-step strengthening, after a plurality of batches of samples have been continuously strengthened in the salt bath of each step, if the surface CS of a batch of samples decreases to 10% to 20% of that of the initial batch, the glass strengthening in the salt bath is stopped, and it is necessary to remove impurities in the salt bath or replace the salt bath for glass strengthening.

In some embodiments of the present application, the strengthened glass ceramic comprises a compressive stress layer and a tensile stress layer; the main crystalline phase of the strengthened glass ceramic is $(Zn, Mg)Al_2O_4$, and the secondary crystalline phase comprises tetragonal zirconia; and the composition of the strengthened glass ceramic is substantially free of $Li_2O$, with less than 0.01% $Li_2O$ in mol%.

It should be understood that the composition at the surface of the glass ceramic or the base glass after an ion exchange process of chemical strengthening may be different from that of the newly formed glass ceramic or base glass (i.e., the glass ceramic or the base glass that has not been subjected to ion exchange). That is, in the present application, the composition of the compressive stress layer formed by ion exchange on the surface of the strengthened glass ceramic may be different from that of the above lithium-free transparent spinel glass ceramic (i.e., glass ceramic for chemical strengthening). This is because during ion exchange, one type of alkali metal ions (e.g., $Li^+$ or $Na^+$) in the newly formed glass ceramic is replaced by a larger alkali metal ion (e.g., $Na^+$ or $K^+$), respectively. For example, $Na^+$ in the glass is exchanged with $K^+$ in the salt bath for strengthening and replaced by $K^+$, and/or $Li^+$ in the glass is exchanged with $Na^+$ in the salt bath for strengthening and replaced by $Na^+$. However, in some embodiments, the composition of the glass ceramic or the base glass at or near the center of the depth of a glass product will still have the composition of the newly formed glass ceramic or base glass. That is, in the present application, the composition of the tensile stress layer of the strengthened glass ceramic will still have the composition of the above lithium-free transparent spinel glass ceramic of the present application.

In the present application, since the exchange of alkali metal ions is occurred during the chemical strengthening process while the main crystalline phase $(Zn, Mg)Al_2O_4$ and the secondary crystalline phase including tetragonal $ZrO_2$ of the lithium-free transparent spinel glass ceramic of the present application do not participates in the ions exchange, the main crystalline phase of the strengthened glass ceramic obtained after chemical strengthening is still $(Zn, Mg)Al_2O_4$, and the secondary crystalline phase still includes tetragonal $ZrO_2$.

The present application carries out an in-depth study on the intrinsic strength of the lithium-free transparent spinel glass ceramic and the stress characteristics of the glass ceramic that can be obtained after strengthening, and by strengthening a specific system of lithium-free transparent spinel glass ceramic having a high intrinsic strength to meet specific stress characteristics, a strengthened glass ceramic with excellent mechanical performances, such as an excellent drop resistance performance, was finally obtained. In the present application, the strengthened glass ceramic are endowed with excellent surface stress characteristics and deep-layer stress characteristics through the chemical strengthening process, and combined with the original high intrinsic strength of lithium-free transparent spinel glass ceramic, the mechanical performance of the strengthened glass ceramic are finally greatly improved, so that the strengthened glass ceramic can achieve a drop resistance performance far superior to the existing spinel glass ceramic.

In some embodiments of the present application, the strengthened glass ceramic satisfies: depth of compressive stress layer DOL_0 ≥ 0.13 t, preferably 0.22 t ≥ DOL_0 ≥ 0.15 t, wherein t is the thickness of the strengthened glass ceramic. In some embodiments of the present application, DOL_0 can be 0.15 t to 0.21 t, 0.15 t to 0.20 t, 0.15 t to 0.19 t, 0.15 t to 0.18 t, 0.15 t to 0.17 t, 0.16 t to 0.21 t, 0.17 t to 0.21 t, 0.18 t to 0.21 t or 0.19 t to 0.21 t. In some embodiments of the present application, the DOL_0 of the above strengthened glass ceramic can be 0.13 t, 0.15 t, 0.16 t, 0.17 t, 0.18 t, 0.19 t, 0.20 t, 0.21 t or 0.22 t, or any value within a numerical range formed of any two of the above specified values as endpoints. Exemplarily, when the thickness of strengthened glass ceramic is 0.7 mm, the depth of compressive stress layer DOL_0 is $\geq$ 91.00 $\mu$m, preferably 105 to 154 $\mu$m, and the depth of compressive stress layer DOL_0 can be 91.00 $\mu$m, 105.00 $\mu$m, 112.00 $\mu$m, 119 $\mu$m, 126.00 $\mu$m, 133.00 $\mu$m, 140.00 $\mu$m, 147.00 $\mu$m or 154.00 $\mu$m, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the thickness t of the strengthened glass ceramic is 0.2 to 5.0 mm, preferably 0.3 to 2.0 mm, and more preferably 0.4 to 1.5 mm.

In some embodiments of the present application, the strengthened glass ceramic satisfies: |CT_CV| $\geq$ 80 MPa, preferably 300 MPa $\geq$ |CT_CV| $\geq$ 80 MPa. In some embodiments of the present application, |CT_CV| can be 80 to 280 MPa, 80 to 260 MPa, 80 to 240 MPa, 80 to 220 MPa, 80 to 200 MPa, 80 to 180 MPa, 80 to 160 MPa, 100 to 280 MPa, 120 to 280 MPa, 140 to 280 MPa, 160 to 280 MPa or 180 to 280 MPa. In some embodiments of the present application, the |CT_CV| of the above strengthened glass ceramic can be 80 MPa, 100 MPa, 120 MPa, 140 MPa, 160 MPa, 180 MPa, 200 MPa, 220 MPa, 240 MPa, 260 MPa, 280 MPa or 300 MPa, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the strengthened glass ceramic satisfies: |CT_AV| $\geq$ 70 MPa, preferably 200 MPa $\geq$ |CT_AV| $\geq$ 70 MPa. In some embodiments of the present application, |CT_AV| can be 70 to 180 MPa, 70 to 160 MPa, 70 to 140 MPa, 70 to 120 MPa, 70 to 100 MPa, 90 to 180 MPa, 110 to 180 MPa, 130 to 180 MPa or 150 to 180 MPa. In some embodiments of the present application, the |CT_AV| of the above strengthened glass ceramic can be 70 MPa, 90 MPa, 110 MPa, 120 MPa, 140 MPa, 160 MPa, 180 MPa or 200 MPa, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the strengthened glass ceramic satisfies: CS_50 $\geq$ 100 MPa, preferably 500 MPa $\geq$ CS_50 $\geq$ 140 MPa. In some embodiments of the present application, CS_50 can be 140 to 480 MPa, 140 to 460 MPa, 140 to 440 MPa, 140 to 420 MPa, 140 to 400 MPa, 140 to 380 MPa, 140 to 360 MPa, 140 to 340 MPa, 160 to 480 MPa, 180 to 480 MPa, 200 to 480 MPa, 220 to 480 MPa, 240 to 480 MPa, 260 to 480 MPa or 280 to 480 MPa. In some embodiments of the present application, the CS_50 of the above strengthened glass ceramic can be 100 MPa, 140 MPa, 160 MPa, 180 MPa, 200 MPa, 220 MPa, 240 MPa, 260 MPa, 280 MPa, 300 MPa, 320 MPa, 340 MPa, 360 MPa, 380 MPa, 400 MPa, 420 MPa, 440 MPa, 460 MPa, 480 MPa or 500 MPa, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the strengthened glass ceramic satisfies: CT_LD is 40000 MPa/mm to 85000 MPa/mm, preferably 45000 MPa/mm to 85000 MPa/mm, and more preferably 48000 MPa/mm to 85000 MPa/mm. In some embodiments of the present application, CT_LD can be 40000 to 80000 MPa/mm, 40000 to 75000 MPa/mm, 40000 to 70000 MPa/mm, 40000 to 65000 MPa/mm, 40000 to 60000 MPa/mm, 45000 to 85000 MPa/mm, 50000 MPa/mm to 85000 MPa/mm, 55000 MPa/mm to 85000 MPa/mm, 60000 MPa/mm to 85000 MPa/mm or 65000 MPa/mm to 85000 MPa/mm. In some embodiments of the present application, the tensile stress linear density CT_LD of the above strengthened glass ceramic can be 40000 MPa/mm, 45000 MPa/mm, 50000 MPa/mm, 55000 MPa/mm, 60000 MPa/mm, 65000 MPa/mm, 70000 MPa/mm, 75000 MPa/mm, 80000 MPa/mm or 85000 MPa/mm, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the surface $K_2O$ concentration of the strengthened glass ceramic is $\geq$ 9.00 wt.%, preferably 9.00 to 16.00 wt.%. In some embodiments of the present application, the surface $K_2O$ concentration of the strengthened glass-ceramics may be 9.00 to 15.00 wt.%, 9.00 to 14.00 wt.%, 9.00 to 13.00 wt.%, 9.00 to 12.00 wt.%, 9.00 to 11.00 wt.%, 10.00 to 16.00 wt.%, 11.00 to 16.00 wt.%, 12.00 to 16.00 wt.%, 13.00 to 16.00 wt.% or 14.00 to 16.00 wt.%. In some embodiments of the present application, the surface $K_2O$ concentration of the above strengthened glass ceramic can be 9.00 wt.%, 10.00 wt.%, 11.00 wt.%, 12.00 wt.%, 13.00 wt.%, 14.00 wt.%, 15.00 wt.% or 16.00 wt.%, or any value within a numerical range formed of any two of the above specified values as endpoints. It should be understood that in specific embodiments, any of the above ranges may be combined with any other ranges, as long as a glass with a desired property of the present application is obtained.

It should be understood that the strengthened glass ceramic of the present application is obtained by a chemical strengthening treatment of the above lithium-free transparent spinel glass ceramic provided by the present application. However, in the lithium-free transparent spinel glass ceramic of the present application, the main crystalline phase (Zn, Mg)$Al_2O_4$ and the secondary crystalline phase comprising tetragonal $ZrO_2$ do not comprise alkali metals and does not participate in the ion exchange, and thus the composition of crystalline phase is substantially unchanged before and after the strengthening.

In some embodiments of the present application, the crystallinity of the strengthened glass ceramic is ≥ 20.00 wt.%; preferably, the crystallinity is 20.00 to 50.00 wt.%; further preferably, the crystallinity is 30.00 to 50.00 wt.%; and more preferably, the crystallinity is 35.00 to 45.00 wt.%.

In some embodiments of the present application, in the strengthened glass ceramic, the average grain size is ≤ 15.0 nm, preferably 1.0 to 15.0 nm, further preferably 1.0 to 10.0 nm, and more preferably 4.5 to 8.0 nm.

It should be understood that in the present application, after chemical strengthening treatment, the composition of the crystalline phase in the glass ceramic is substantially unchanged, and the optical performance of the glass ceramic, such as transmittance and optical b-value, are also substantially unchanged.

In some embodiments of the present application, the strengthened glass ceramic is transparent in the visible light range. Preferably, for light at a wavelength of 550 nm, the transmittance of the strengthened glass ceramic with a thickness of 0.7 mm is greater than or equal to 85%, preferably greater than or equal to 89%; and/or the absolute value of the optical b-value of the strengthened glass ceramic with a thickness of 0.7 mm is 0.20 to 1.50, preferably 0.50 to 1.20.

In some embodiments of the present application, the Vickers hardness of the strengthened glass ceramic is 700 to 900 kgf/mm$^2$. In some embodiments of the present application, the Vickers hardness of the strengthened glass ceramic may be 700 to 890 kgf/mm$^2$, 700 to 880 kgf/mm$^2$, 700 to 870 kgf/mm$^2$, 700 to 860 kgf/mm$^2$, 700 to 850 kgf/mm$^2$, 700 to 840 kgf/mm$^2$, 700 to 830 kgf/mm$^2$, 700 to 820 kgf/mm$^2$, 700 to 810 kgf/mm$^2$, 700 to 800 kgf/mm$^2$, 710 to 900 kgf/mm$^2$, 720 to 900 kgf/mm$^2$, 730 to 900 kgf/mm$^2$, 740 to 900 kgf/mm$^2$, 750 to 900 kgf/mm$^2$, 760 to 900 kgf/mm$^2$, 770 to 900 kgf/mm$^2$, 780 to 900 kgf/mm$^2$, 790 to 900 kgf/mm$^2$ or 800 to 900 kgf/mm$^2$. In some embodiments of the present application, the Vickers hardness of the above strengthened glass ceramic may be 700 kgf/mm$^2$, 710 kgf/mm$^2$, 720 kgf/mm$^2$, 730 kgf/mm$^2$, 740 kgf/mm$^2$, 750 kgf/mm$^2$, 760 kgf/mm$^2$, 770 kgf/mm$^2$, 780 kgf/mm$^2$, 790 kgf/mm$^2$, 800 kgf/mm$^2$, 810 kgf/mm$^2$, 820 kgf/mm$^2$, 830 kgf/mm$^2$, 840 kgf/mm$^2$, 850 kgf/mm$^2$, 860 kgf/mm$^2$, 870 kgf/mm$^2$, 880 kgf/mm$^2$, 890 kgf/mm$^2$ or 900 kgf/mm$^2$, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the fracture toughness of the strengthened glass ceramic is greater than or equal to 1.00 MPa•m$^{1/2}$, preferably greater than or equal to 1.20 MPa·m$^{1/2}$, and further preferably greater than or equal to 1.50 MPa•m$^{1/2}$. In some embodiments of the present application, the fracture toughness can be 1.00 to 2.00 MPa•m$^{1/2}$, 1.20 to 2.00 MPa•m$^{1/2}$ 1.40 to 2.00 MPa•m$^{1/2}$, 1.50 to 2.00 MPa•m$^{1/2}$, 1.00 to 1.80 MPa•m$^{1/2}$, 1.00 to 1.60 MPa•m$^{1/2}$ 1.00 to 1.40 MPa•m$^{1/2}$ or 1.00 to 1.20 MPa•m$^{1/2}$. In some embodiments of the present application, the fracture toughness can be 1.00 MPa•m$^{1/2}$, 1.20 MPa•m$^{1/2}$, 1.30 MPa•m$^{1/2}$, 1.40 MPa•m$^{1/2}$, 1.50 MPa•m$^{1/2}$ 1.51 MPa•m$^{1/2}$, 1.57 MPa•m$^{1/2}$, 1.60 MPa•m$^{1/2}$, 1.64 MPa•m$^{1/2}$, 1.66 MPa-m$^{1/2}$, 1.70 MPa•m$^{1/2}$, 1.80 MPa•m$^{1/2}$, 1.90 MPa•m$^{1/2}$ or 2.00 MPa•m$^{1/2}$, or any value within a numerical range formed of any two of the above specified values as endpoints. It should be understood that in specific embodiments, any of the above ranges may be combined with any other ranges, as long as a glass with a desired property of the present application is obtained.

It should be understood that after chemical strengthening, the Young modulus of the glass ceramic will increase appropriately. The Young modulus of the lithium-free transparent spinel glass ceramic provided in this application is ≥ 100 GPa, preferably, the Young modulus is ≥ 110 GPa, more preferably 114 GPa ≤ Young modulus ≤ 140 GPa. Therefore, the Young modulus of the strengthened glass ceramic is ≥ 100 GPa, preferably, the Young modulus is ≥ 110 GPa, more preferably 114 GPa ≤ Young modulus ≤ 140 GPa.

In some embodiments of the invention, the strengthened glass ceramic of the invention with a thickness of 0.7 mm are tested for sandpaper drop resistance by using 120-mesh sandpaper. At least 10 samples of the same strengthened glass ceramic are tested for sandpaper drop resistance in the present application, and the average of the sandpaper drop resistance height of the strengthened glass ceramic samples is calculated to obtain the average sandpaper drop resistance height of the strengthened glass ceramic. The average sandpaper drop resistance height of the strengthened glass ceramic is greater than 1.5 m, preferably greater than or equal to 1.80 m, further preferably 1.80 to 2.50 m, and more preferably 2.00 to 2.50 m. In some embodiments of the present application, the average sandpaper drop resistance height of the strengthened glass ceramic may be 1.80 m, 2.00 m, 2.10 m, 2.20 m, 2.30 m, 2.40 m or 2.50 m, or any value within a numerical range formed of any two of the above specified values as endpoints. It should be understood that in specific embodiments, any of the above ranges may be combined with any other ranges, as long as a glass with a desired property of the present application is obtained.

In some embodiments of the present application, the strengthened glass ceramic of the present application with a thickness of 0.7 mm is subjected to a 2.5 meter (m) drop test with a 120-mesh sandpaper. If a glass sample does not break after falling, it is recorded as passed. At least 10 samples of the same strengthened glass ceramic are subjected to the 2.5 m drop test in this invention, and the pass rate of the strengthened glass ceramic samples is calculated. The pass rate of the strengthened glass ceramic is greater than or equal to 50%, preferably greater than or equal 60%, more preferably greater than or equal 70%, and even more preferably, the pass rate is 60% to 100%. In some embodiments of the present application, the pass rate of the strengthened glass ceramic in the 2.5 m drop test (120-mesh sandpaper) may be 60%, 70%, 80%, 90% or 100%, or the pass rate of the 2.5 m drop test (120-mesh sandpaper) is within a numerical range formed of any two of the above specified values as endpoints. It should be understood that in specific embodiments, any of the above ranges may be combined with any other ranges, as long as a glass with a desired property of the present application is obtained.

In a fourth aspect, the lithium-free transparent spinel glass ceramic or the base glass for preparing the lithium-free transparent spinel glass ceramic or the chemically strengthened glass provided by the present application can be used in a mobile phone display screen, a tablet computer display screen, a hand-held game console, an electronic terminal, a portable digital device, a vehicle center control screen, an electronic whiteboard glass, a smart home touch screen, a vehicle windshield glass, a flight vehicle windshield glass, or an aircraft windshield glass.

The following is a detailed description of how to prepare the lithium-free transparent spinel glass ceramic and the beneficial effects obtained through examples and comparative examples.

**1: Examples of the specific operations**

**Example 1**

The raw materials (industrial conventional raw materials) were prepared and placed in a platinum crucible according to the composition ratio of the glass formulation 1 of Example 1 in Table 1. The total amount of the raw materials was 1000 g. Then the raw materials were mixed with a V-type mixer for 30 minutes, after which 5 g of clarifying agent NaCl was added. Then the raw materials were transferred to the platinum crucible, and melted in a 1650 °C elevator furnace (elevator furnace model: SJF1750, manufacturer: Nanjing Boyuntong Instrument Technology Co., Ltd.) for 5 hours. Then it was poured into a stainless steel mold preheated to 300 °C (usually preheated to 200 to 400 °C) for molding and cooling. After cooled to 900 °C, the product obtained was annealed in an annealing lehr at 600 °C for 24 hours, and then cooled to room temperature in the furnace to obtain a base glass.

The above base glass was subjected to a heat treatment in a resistance furnace (equipment model: SLX1400-40, manufacturer: Shanghai Shengli Instrument Co., Ltd.), and the heat treatment process (nucleation temperature/nucleation time, crystallization temperature/crystallization time, heating rate during the heat treatment) was performed according to Table 1 to obtain a sample brick of a lithium-free transparent spinel glass ceramic. The sample brick of the lithium-free transparent spinel glass ceramic was cut, processed by CNC (computer numerical control, i.e., computer numerical control machine tool; the model of CNC equipment used in the present application is RCG500S) and polished successively to obtain a smooth sheet of the lithium-free transparent spinel glass ceramic. In the present application, the specification of the processed glass ceramic sheet is a sample with a length, width and thickness of 50 mm × 50 mm × 0.7 mm.

Physical parameters of the prepared glass ceramic were tested according to the following methods:

Test of Young modulus: the Young modulus of the obtained samples was tested by acoustic wave with the instrument UMS-100 Ultrasonic Material Characterization System.

XRD test: the glass ceramic sheets were ground into fine glass powders with a particle size of less than 75 $\mu$m by a mill, and then tested by an X-ray diffractometer (XRD-6100 of Shimadzu) to obtain the XRD diffraction peak profile. In the present application, the X-ray diffractometer used is XRD-6100 from Shimadzu; the target material was copper, the test incidence angle range was 2$\theta$=10° to 80 °, the scanning speed was 0.2 °/minute, the operating voltage was 40 kV, and the operating current was 30 mA. JADE software was used to analyze the XRD data to determine the crystalline phase of the samples.

Average grain size: according to Scherrer formula $D=K\lambda/(\beta\cos\theta)$, the average grain size of the samples were calculate from the resultant data obtained from the XRD test, wherein $\lambda$ is the X-ray wavelength, i.e., 0.154056 nm, $\beta$ is the full width at half maximum of the diffraction peak, K=0.89, and $\theta$ is the Bragg diffraction angle. Specifically, the RAW file exported by the XRD instrument was subjected to profile-fitting in Jade software, and a fitting report was exported by Jade. Based on the angle 2θ value and peak FWHM value (full width at half maximum of the diffraction peak) corresponding to each diffraction peak in the fitting report, the average grain size is obtained by calculating and averaging the grain sizes of the diffraction peaks based on the formula $D=K\lambda/(\beta\cos\theta)$, where the peak FWHM value is converted to radian via $\beta=(FWHM/180*3.14)$.

Test method of crystal content/crystallinity: Result files of the X-ray diffractometer test (RAW format) were imported into an X-ray diffraction data Rietveld refining software (e.g., Gsas, Fullprof, Maud), and then fitting and calculation were carried out to obtain the crystal content/crystallinity of the glass ceramic samples. The crystal content corresponds to the ratio of the fitted peak area of the crystalline phase to the fitted whole peak area, which is also referred to as the crystallinity of the present application.

Determination of b-value: the b-value was obtained by testing the samples with a Konica Minolta spectrophotometer CM-3600A, Japan, and the average value of 5 parallel samples was taken as the b-value of the samples to be tested.

Transmittance determination: the test was performed by referring to the standard GB/T 7962.12-2010 Test Methods of Colorless Optical Glass - Part 12: Spectral internal transmittance. Firstly, the glass ceramic sample to be tested was cleaned in an ultrasonic cleaning machine, wherein the cleaning conditions were as follows: cleaning time: 5 to 10 minutes; cleaning agent used: common detergent that diluted 10 times; cleaning temperature: 45 °C to 65 °C; cleaning frequency: 20 kHz to 40 kHz. Then, a haze meter (Konica Minolta spectrophotometer CM-3600A) was used to test the transmittance under different wavelengths of light.

The transmittance of the samples at 550 nm wavelength was measured by Konica Minolta spectrophotometer CM-3600A, Japan, and the average of five parallel samples was taken as the transmittance result of the samples to be tested at 550 nm wavelength.

Thickness of glass: determined by a micrometer. It should be understood that in the thickness direction, the degree of ion exchange varies in gradient from surface to center, while the total exchange amount of Na-K and/or Li-Na generally does not exceed 1% of the total mass of the sample, and the difference in ion radius is of pm level, so the expansion effect in the thickness direction is extremely slight, and it can be approximately considered that the thickness is basically unchanged.

Density determination: the density value of glass ceramic samples was measured according to the principle of Archimedes drainage method. The testing instrument applied in the present application is ALFA MIRAGE Electronic Density Balance SD-200L.

After the above performance tests were completed, the glass ceramic sample obtained above with a thickness of 0.7 mm was subjected to a chemical strengthening treatment according to the conditions shown in Table 2, i.e., mixed or single molten salt composition, ion exchange temperature of each step and ion exchange time, to obtain the strengthened glass ceramic.

Among them, the samples were strengthened in a single step based on the following specific process:
IOX (ion exchange): 480 °C × 100% $KNO_3$ × 24 h (i.e., exchanging in a 100 wt.% $KNO_3$ molten salt at 480 °C for 24 h; similar expressions in the present disclosure have similar meanings, namely, the temperature and composition of the molten salt and the ion exchange time used for ion exchange are expressed in such abbreviated form).

Physical parameters of the prepared strengthened glass ceramic were tested according to the following methods.

In the present application, CS_50, |CT_CV|, |CT_AV|, and DOL_0 were tested with a stress meter SLP-2000 from Orihara, Japan. The test conditions were as follows: light source wavelength is 518 nm, SOC=25.5 (nm/cm)/MPa, refractive index =1.60, and exposure time is 300 microsecond ($\mu$s). During the test of CS_50, |CT_CV|, |CT_AV|, and DOL_0, it is necessary to put a drop of its special refractive solution on the stress meter, then wipe the strengthened glass ceramic product clean and put it on the test path to test its stress value. The refractive index of the refractive solution used for SLP-2000 is 1.51. Unless otherwise specified, in the examples and comparative examples of the present application, the stress values were tested based on the above test conditions. It should be noted that when testing the stress values of Comparative Examples 10-15, the photoelasticity constant was set to 25.5 and the refractive index nd was set to 1.6; when testing the stress value of Comparative Example 7, the photoelasticity constant was set to 25.5 and the refractive index nd was set to 1.54; and when testing the stress value of Comparative Example 8, the photoelasticity constant was set to 28.6 and the refractive index nd was set to 1.51.

The tensile stress linear density CT_LD is related to the thickness, strengthening depth and average tensile stress of a glass sheet, and can be used to evaluate the drop resistance performance of the glass sheet. In the present application, the CT_LD is calculated according to the following formula:

$$CT\_LD = \frac{(1000t/2 - DOL\_0) \times |CT\_AV| \times 2}{t}$$

wherein t represents the thickness of the glass ceramic sheet in mm (the glass thickness in the following examples and comparative examples of the present application is 0.7 mm); DOL_0 represents the depth of compressive stress layer in $\mu$m; CT_AV represents the internal average tensile stress, and its absolute value in MPa is taken during calculation. It should be understood that, in the calculation formula of tensile stress linear density, the data is substituted into the calculation according to the above unit requirements and the calculation results are obtained without the units being involved in the calculation.

Calculation of the exchange amount: the exchange amount is the ratio of the mass difference of a glass ceramic before and after chemical strengthening to the mass of the glass ceramic before chemical strengthening.

Surface $K_2O$ concentration test: in the present application, the $K_2O$ concentration on the surface of the strengthened glass ceramic was measured by an X-ray fluorescence spectrometer (XRF), the model of the equipment used was (Thermo Scientific ARL PERFORM'X), the target material was Rh (rhodium), the voltage of the light tube was 40 kW, the current was 60 mA, the collimator was 0.15, the crystal was LiF200, the detector was FPC, the test range was 29 mm circle, and the analysis software was UniQuant standardless analysis.

Vickers hardness (HV) test: the chemically strengthened glass ceramic was made into small pieces with a length, width and thickness of 50 mm*50 mm*0.7 mm, and glass samples with clean surface and no visible scratches, pits and cracks were selected as the test samples, and then the Vickers hardness was measured by a Vickers hardness tester. The Vickers hardness tester used in the present is a digital display low load Vickers hardness tester (Beijing Kewei Technology Co., Ltd, VTD405). Test conditions: load 300 gf, load time 10 s, the validity of the indentation is in accordance with the standard GB/T 37900-2019 Test Method of Hardness and Fracture Toughness for Ultra-thin Glass - Low-load Vickers Hardness Indentation Method. Three different positions on the surface of the same test sample were selected and subjected to measurement, and the average of the three measurement results was determined as the Vickers hardness of the glass sample to be tested.

Fracture toughness Test: test was performed according to the standard GB/T 37900-2019 Test Method of Hardness and Fracture Toughness for Ultra-thin Glass - Low-load Vickers Hardness Indentation Method. Specifically, indentation was prepared by the same method as in Vickers hardness measurement, and the crack lengths $2C_1$ and $2C_2$ in the diagonal directions of the indentations were measured, provided that the maximum value thereof cannot exceed the thickness of the glass. At least 5 effective indentation morphologies are measured on the surface of a sample, and the average value is calculated as the final result value of the sample.

Calculation formula for indentation fracture toughness:

$$IFR = 0.026 \left[ E \cdot \frac{F}{\frac{(2C_1 + 2C_2)}{4}} \right] \cdot \frac{d_1 + d_2}{2C_1 + 2C_2},$$

wherein, IFR: indentation fracture toughness, with a unit of megapascal ·meter to the power of one-half (MPa ·m$^{1/2}$); E: elastic modulus of the sample, in GPA; $2C_1$, $2C_2$: crack propagation length in diagonal directions of indentation, in millimeters (mm), $d_1$ and $d_2$: diagonal length of indentation, in millimeters (mm), and F: test load value, in newtons (N).

Average drop resistance height test: the average sandpaper drop resistance height is the sum of the sandpaper drop resistance height of each sample measured in multiple slices of the same glass samples divided by the number of glass samples, i.e., the average value was used to characterize the drop resistance performance of the of glass ceramic. At least 10 pieces of the same glass samples are taken in each batch for testing, and the average sandpaper drop resistance height is:

$$\langle h \rangle n = \frac{1}{n} \sum_{i=1}^{n} hi \quad ;$$

wherein n is the number of glass samples tested in each batch, and hi is the sandpaper drop resistance height of a single sample.

Specifically, the test method of the sandpaper drop resistance height of a single sample is as follows:

step 1: sticking a 120-mesh sandpaper on the lower surface of a 160 g model machine, and putting the model machine on a LT-SKDL-CD drop machine from LvTu company;

step 2: placing a glass sample to be tested with a length, width and thickness of 50 mm*50 mm*0.7 mm directly underneath the model machine, so that the glass sample faces the sandpaper; allowing the model machine to drop from a certain drop height and impact the glass sample directly under the model machine; if the glass sample does not break, raising the drop height of the model machine at regular height intervals and repeating the drop until the glass sample breaks; for example, the glass sample may be subjected to the first drop impact staring with a drop height of 0.4 m, and in case that the glass sample does not break, the height should be increased by 0.1 m each time and the drop repeated; and

step 3: recording the last falling height before the glass sample was broken as the sandpaper drop resistance height; for example, if the drop height increases by 0.1 m each time and when the glass sample breaks the drop height is 0.5 m, then the sandpaper drop resistance height of the sample is 0.4 m.

Test method of 2.5 m drop test pass rate: 2.5 m drop test pass rate refers to the percentage of passing samples calculated by dividing the number of passing samples by the total number of testing samples after a drop test of multiple identical glass samples from 2.5 m height. After the drop test, if the glass sample was not broken, it is regarded as passed, or it is regarded as failed. This is used to characterize the drop resistance of the glass ceramic. At least 10 pieces of the identical glass ceramic samples are taken from each batch for testing.

Specifically, the test method of the 2.5 m drop test for a single sample is as follows:

step 1: sticking a 120-mesh sandpaper on the lower surface of a 160 g model machine, and putting the model machine on a LT-SKDL-CD drop machine from LvTu company;

step 2: placing a glass sample to be tested with a length, width and thickness of 50 mm*50 mm*0.7 mm directly underneath the model machine, so that the glass sample faces the sandpaper; and allowing the model machine to drop from a 2.5 m drop height and impact the glass sample directly under the model machine, wherein if the glass sample was not broken, it is regarded as passed, or it is regarded as failed.

Test of failure time at high temperature and high humidity: the test was conducted by a QTH_80C temperature and humidity alternating test chamber from QuanYI company, and the conditions of the alternating test chamber are set as follows: temperature of 85 °C and relative humidity of 85%. The sample sheets were taken out at intervals of 12 h, and the glass surface was wiped with a dust-free cloth to observe whether there is a spot or fog point that cannot be wiped off. After observation, the samples were put back into the test chamber. If in a certain observation, there is a spot or fog point that cannot be wiped off on a sample sheet, while in the last time when the sample sheet was taken out for observation there was no spot or fog spot that could not be wiped off, then the time when the sample sheet was taken out during this observation is taken as a node, and the length of time the glass sample sheet is placed in the test chamber is calculated and recorded as the failure time at high temperature and high humidity of the sample sheet, which is used for the characterization of the weatherability.

Examples 2 to 5 were operated under the same operating conditions as in Example 1 and tested accordingly. Table 1 shows the composition of the glass formulations for preparing the base glass of Examples 1 to 5, the heat treatment processes, and the performance parameters of the lithium-free transparent spinel glass ceramic prepared therefrom. Table 2 shows the strengthening conditions of the lithium-free transparent spinel glass ceramic of Examples 1 to 5 and the performance parameters of the strengthened glass ceramic prepared therefrom.

Table 1 Base glass formulations, results of melting process, heat treatment processes and performance parameters of lithium-free transparent spinel glass ceramic prepared therefrom of Examples 1 to 5

| Scheme Number | Example 1 | Example 2 | Example 3 | Example 4 | Example 5 |
|---|---|---|---|---|---|
| Base Glass Formulation (in mol% of the oxides) | Formulation 1 | Formulation 2 | Formulation 3 | Formulation 4 | Formulation 5 |
| $SiO_2$ | 43. 27 | 38.64 | 40.26 | 41.28 | 41.23 |
| $Al_2O_2$ | 26. 33 | 27. 89 | 25.91 | 26. 89 | 26. 54 |
| $ZrO_2$ | 3. 46 | 3.31 | 3.84 | 3.42 | 3. 37 |
| MgO | 5. 78 | 5.52 | 5. 49 | 5.70 | 5. 63 |
| ZnO | 9. 92 | 9. 48 | 9. 42 | 9. 79 | 9. 66 |
| $Na_2O$ | 7. 39 | 9.65 | 9.60 | 8. 63 | 9.83 |
| $K_2O$ | 0. 00 | 0.00 | 0.00 | 0.50 | 0. 00 |
| $B_2O_3$ | 3.85 | 5.51 | 5. 48 | 3.79 | 3. 74 |
| $Y_2O_3$ | 0. 00 | 0.00 | 0.00 | 0. 00 | 0. 00 |
| $Al_2O_3$-MgO-ZnO, mol% | 10. 63 | 12. 89 | 11. 00 | 11. 40 | 11. 25 |
| X, % | 34. 27 | 40. 59 | 34. 82 | 36. 49 | 35. 77 |
| Y, % | 60. 00 | 73. 86 | 68. 92 | 66. 80 | 70. 84 |
| A | 0.14 | 0.08 | 0. 09 | 0. 13 | 0.12 |
| B | 0. 64 | 0. 74 | 0.73 | 0.69 | 0.73 |
| Result of Melting Process | Transparent | Transparent | Transparent | Transparent | Transparent |
| Heat Treatment Process | Example 1 | Example 2 | Example 3 | Example 4 | Example 5 |
| Nucleation Temperature/ Nucleation Time | 700°C /240min | 690°C /240min | 700°C /240min | 720°C /240min | 720°C /240min |

(continued)

| Heat Treatment Process | Example 1 | Example 2 | Example 3 | Example 4 | Example 5 |
|---|---|---|---|---|---|
| **Crystallization Temperature/ Crystallization Time** | 800°C /240 min | 740°C /240min | 750°C /240min | 780°C /240min | 780°C /240min |
| **Heating Rate, K/min** | 10 | 10 | 10 | 10 | 10 |
| **Performance Parameter** | Example 1 | Example 2 | Example 3 | Example 4 | Example 5 |
| **Crystalline Phase A** | ( Zn. Mg ) $Al_2O_4$ | ( Zn, Mg) $Al_2O_4$ | ( Zn, Mg ) $Al_2O_4$ | ( Zn , Mg ) $Al_2O_4$ | ( Zn, Mg ) $Al_2O_4$ |
| **Crystalline Phase B** | $ZrO_2$ | $ZrO_2$ | $ZrO_2$ | $ZrO_2$ | $ZrO_2$ |
| **Crystalline Phase C** | - | - | - | - | - |
| **Average Crystal Size, nm** | 7.4 | 5.3 | 6.1 | 6. 2 | 4.9 |
| **Crystallinity, wt%** | 40. 41 | 38. 50 | 38. 92 | 39. 05 | 38.81 |
| **b-value** | 0. 83 | 0.76 | 0.52 | 0. 61 | 0.53 |
| **550 nm Transmittance (%)** | 90. 40 | 89. 68 | 89. 83 | 89. 81 | 90. 50 |
| **Young modulus (GPa)** | 117 | 114 | 116 | 113 | 116 |
| **Density, g/cm$^3$** | 2.9516 | 2.9804 | 2.9912 | 3. 0112 | 3. 0236 |

Table 2 Chemical strengthening conditions of lithium-free transparent spinel glass ceramic of Examples 1 to 5 and performance parameters of the strengthened glass ceramic prepared therefrom

| Scheme Number | Example 1 | Example 2 | Example 3 | Example 4 | Example 5 |
|---|---|---|---|---|---|
| **Thickness of Lithium-free Transparent Spinel Glass Ceramic, mm** | 0. 7 | 0. 7 | 0. 7 | 0. 7 | 0. 7 |
| **Ion Exchange Method** | Single-Step Strengthening IOX: 480°C × 100%KNO$_3$ × 24h | Single-Step Strengthening IOX: 480°C × 100%KNO$_3$ × 24h | Single-Step Strengthening IOX: 480°C × 100%KNO$_3$ × 24h | Single-Step Strengthening IOX: 480°C × 100%KNO$_3$ × 22h | Single-Step Strengthening IOX: 480°C × 100%KNO$_3$ × 12h |
| \|CT_CV\|, MPa | 110. 84 | 129. 98 | 103. 67 | 89. 07 | 113. 02 |
| CS_50, MPa | 257. 26 | 302. 03 | 250. 76 | 197. 46 | 188. 08 |
| DOL_0, $\mu$m | 108. 69 | 122. 96 | 112. 26 | 116. 00 | 114. 30 |
| \|CT_AV\|/MPa | 95.07 | 108. 92 | 88.55 | 79. 80 | 99.43 |
| CT_LD/ (MPa/mm) | 65547 | 70655 | 60148 | 53352 | 66959 |
| **Exchange Amount, %** | 0.44 | 0.49 | 0.40 | 0.30 | 0.28 |
| **Surface K$_2$O Content, wt%** | 12. 00 | 12. 78 | 11. 13 | 10. 63 | 10. 26 |
| **Average Sandpaper Drop Resistance Height (m)** | 2.09 | 2. 35 | 2. 09 | 2. 06 | 2. 18 |

(continued)

| Scheme Number | Example 1 | Example 2 | Example 3 | Example 4 | Example 5 |
|---|---|---|---|---|---|
| 2.5 m Drop Test Pass Rate (%) | 90 | 100 | 90 | 70 | 90 |
| Vickers Hardness, $kgf/mm^2$ | 838 | 825 | 811 | 792 | 854 |
| Fracture Toughness $(MPa \cdot M^{1/2})$ | 1. 638 | 1. 608 | 1. 598 | 1.570 | 1.629 |
| Failure Time at High Temperature and High Humidity, h | > 360 | > 360 | > 360 | > 360 | > 360 |

Note: 1. Since the maximum time for conducting the high temperature and high humidity failure test in the present application is 360 h (15 days), if a glass sample still does not have spots and/or foggy spots that cannot be removed by wiping when taken out for observation after 360 h, then the failure time at high temperature and high humidity of the glass sample will be determined to be greater than 360 h. 2. The surface $K_2O$ content in the table is the surface $K_2O$ concentration of the present application.

Examples 6 to 10 were operated under the same operating conditions as in Example 1 and tested accordingly. Table 3 shows the composition of the glass formulations of the prepared base glass of Examples 6 to 10, the heat treatment processes, and the performance parameters of the lithium-free transparent spinel glass ceramic prepared therefrom. Table 4 shows the strengthening conditions of the lithium-free transparent spinel glass ceramic of Examples 6 to 10 and the performance parameters of the strengthened glass ceramic prepared therefrom.

Table 3 Base glass formulations, results of melting process, heat treatment processes of Examples 6 to 10 and performance parameters of the lithium-free transparent spinel glass ceramic prepared therefrom

| Scheme Number | Example 6 | Example 7 | Example 8 | Example 9 | Example 10 |
|---|---|---|---|---|---|
| Base Glass Formulation (in mol% of the oxides) | Formulation 6 | Formulation 7 | Formulation 8 | Formulation 9 | Formulation10 |
| $SiO_2$ | 41.54 | 42. 12 | 38. 47 | 39. 42 | 40. 66 |
| $Al_2O_2$ | 27. 26 | 27. 10 | 27. 77 | 29. 85 | 26. 17 |
| $ZrO_2$ | 3. 46 | 3. 4 4 | 3. 4 8 | 3.42 | 3.33 |
| MgO | 5. 78 | 5. 75 | 6. 11 | 5. 71 | 5. 55 |
| ZnO | 9. 92 | 9. 86 | 10. 33 | 9. 81 | 9. 52 |
| Na2O | 7. 39 | 7. 34 | 7. 51 | 7. 23 | 11. 08 |
| $K_2O$ | 0.80 | 0.00 | 0.00 | 0. 00 | 0. 00 |
| $B_2O_3$ | 3. 85 | 3. 82 | 6. 33 | 4. 56 | 3. 69 |
| $Y_2O_3$ | 0. 00 | 0.57 | 0.00 | 0. 00 | 0. 00 |
| $Al_2O_3$-MgO-ZnO, mol% | 11.56 | 11. 49 | 11. 33 | 14. 33 | 11. 10 |
| X, % | 37. 27 | 37. 25 | 37. 39 | 45. 92 | 35. 04 |
| Y, % | 62. 57 | 62. 53 | 63.91 | 69. 14 | 75. 00 |
| A | 0.14 | 0. 14 | 0. 08 | 0. 14 | 0.11 |
| B | 0.65 | 0.64 | 0.75 | 0.65 | 0.77 |
| Result of Melting Process | Transparent | Transparent | Transparent | Transparent | Transparent |

(continued)

| Heat Treatment Process | Example 6 | Example 7 | Example 8 | Example 9 | Example 10 |
|---|---|---|---|---|---|
| Nucleation Temperature/ Nucleation Time | 690°C /240min | 690°C /240min | 730°C /240min | 680°C /240min | 690°C /240min |
| Crystallization Temperature/ Crystallization Time | 760°C /240min | 760°C /240min | 760°C /240min | 780°C /240min | 750°C /240min |
| Heating Rate, K/min | 10 | 10 | 10 | 10 | 10 |
| Performance Parameter | Example 6 | Example 7 | Example 8 | Example 9 | Example 10 |
| Crystalline Phase A | ( Zn, Mg ) $Al_2O_4$ | ( Zn, Mg ) $Al_2O_4$ | ( Zn, Mg ) $Al_2O_4$ | ( Zn, Mg ) Al1,0, | (Zn, Mg ) $Al_2O_4$ |
| Crystalline Phase B | $ZrO_2$ | $ZrO_2$ | $ZrO_2$ | $ZrO_2$ | $ZrO_2$ |
| Crystalline Phase C | - | - | - | - | - |
| Average Crystal Size, nm | 6. 8 | 7.5 | 6. 8 | 6. 5 | 5.2 |
| Crystallinity, wt% | 38. 40 | 38. 63 | 39. 51 | 39. 01 | 37. 52 |
| b-value | 0. 68 | 1.15 | 0. 53 | 0.65 | 0. 96 |
| 550 nm Transmittance (%) | 89. 36 | 89. 41 | 89. 82 | 89. 24 | 89. 56 |
| Young modulus (GPa) | 114 | 121 | 110 | 115 | 101 |
| Density, g/cm$^3$ | 3. 0659 | 3. 0139 | 3. 0452 | 3. 0457 | 3. 0359 |

Table 4 Chemical strengthening conditions of the lithium-free transparent spinel glass ceramic of Examples 6 to 10 and performance parameters of the strengthened glass ceramic prepared therefrom

| Scheme Number | Example 6 | Example 7 | Example 8 | Example 9 | Example 10 |
|---|---|---|---|---|---|
| Thickness of Lithium-free Transparent Spinel Glass Ceramic, mm | 0. 7 | 0. 7 | 0.7 | 0.7 | 0.7 |
| Ion Exchange Method | Single-Step Strengthening IOX: 480°C × 100%KNO$_3$ × 24h | Single-Step Strengthening IOX: 480°C × 100%KNO$_3$ × 24h | Single-Step Strengthening IOX: 480°C × 100%KNO$_3$ × 24h | Single-Step Strengthening IOX: 480°C × 100%KNO$_3$ × 24h | Single-Step Strengthening IOX: 480°C × 100%KNO$_3$ × 24h |
| [CT_CV], MPa | 95. 71 | 93. 29 | 92. 66 | 92. 67 | 110. 77 |
| CS_50, MPa | 148. 02 | 153. 19 | 155. 00 | 148. 80 | 190. 02 |
| DOL_0, $\mu$m | 114. 20 | 114.60 | 114. 90 | 113. 33 | 115. 60 |
| [CT_AV]/MPa | 77. 90 | 75. 69 | 74. 29 | 73.38 | 98. 90 |
| CT_LD/(MPa/mm) | 52482 | 50907 | 49902 | 49620 | 66235 |
| Exchange Amount, % | 0.40 | 0. 44 | 0.40 | 0.42 | 0.43 |
| Surface K$_2$O Content, wt% | 9. 16 | 9. 21 | 10. 33 | 9. 54 | 9. 32 |
| Average Sandpaper Drop Resistance Height (m) | 2. 02 | 2. 10 | 2. 03 | 2. 10 | 2. 08 |

(continued)

| Scheme Number | Example 6 | Example 7 | Example 8 | Example 9 | Example 10 |
|---|---|---|---|---|---|
| 2.5 m Drop Test Pass Rate (%) | 70 | 70 | 70 | 80 | 70 |
| Vickers Hardness, kgf/mm$^2$ | 847 | 852 | 821 | 830 | 839 |
| Fracture Toughness (MPa·m$^{1/2}$) | 1. 642 | 1.658 | 1.599 | 1.601 | 1.614 |
| Failure Time at High Temperature and High Humidity, h | > 360 | > 360 | > 360 | > 360 | > 360 |
| Note: 1. Since the maximum time for conducting the high temperature and high humidity failure test in the present application is 360 h (15 days), if a glass sample still does not have spots and/or foggy spots that cannot be removed by wiping when taken out for observation after 360 h, then the failure time at high temperature and high humidity of the glass sample will be determined to be greater than 360 h. 2. The surface $K_2O$ content in the table is the surface $K_2O$ concentration of the present application. |||||||

In Examples 11 to 15, the same lithium-free transparent spinel glass ceramic as in Examples 1, 4, and 5, respectively, were subjected to strengthening under different strengthening conditions, and the specific strengthening process used and the performance parameters of the prepared strengthened glass ceramic are specified in Table 5.

Table 5 Chemical strengthening conditions of Examples 11 to 15 and performance parameters of the strengthened glass ceramic prepared therefrom

| Scheme Number | Example 11 | Example 12 | Example 13 | Example 14 | Example 15 |
|---|---|---|---|---|---|
| Lithium-free Transparent Spinel Glass Ceramic | same as Example 1 | same as Example 1 | same as Example 4 | same as Example 4 | same as Example 5 |
| Thickness of Lithium-free Transparent Spinel Glass Ceramic, mm | 0.7 | 0.7 | 0.7 | 0. 7 | 0.7 |
| Ion Exchange Method | Single-Step Strengthening IOX: 480 °C × 100%KNO$_3$ × 48h | Single-Step Strengthening IOX: 530°C× 100%KNO$_3$ × 11h | Single-Step Strengthening IOX: 480°C × 100%KNO$_3$ × 48h | Single-Step Strengthening IOX: 530°C × 100%KNO$_3$ × 9h | Single-Step Strengthening IOX: 480°C × 100%KNO$_3$ × 36h |
| \|CT_CV\|, MPa | 145. 86 | 119. 60 | 136. 94 | 97. 74 | 146. 38 |
| CS_50, MPa | 316. 60 | 263. 23 | 317. 95 | 223. 96 | 337. 69 |
| DOL_0, $\mu$m | 118. 90 | 126. 17 | 126. 00 | 118. 00 | 132. 50 |
| \|CT_AV\|/MPa | 121. 45 | 95.88 | 118. 94 | 86. 08 | 125.91 |
| CT_LD/ (MPa/mm) | 80192 | 61317 | 76122 | 57059 | 78244 |
| Exchange Amount,% | 0.63 | 0. 62 | 0. 55 | 0. 43 | 0. 51 |
| Surface $K_2O$ Content,wt% | 14. 70 | 11. 18 | 15. 21 | 11. 00 | 14. 66 |

(continued)

| Scheme Number | Example 11 | Example 12 | Example 13 | Example 14 | Example 15 |
|---|---|---|---|---|---|
| Lithium-free Transparent Spinel Glass Ceramic | same as Example 1 | same as Example 1 | same as Example 4 | same as Example 4 | same as Example 5 |
| Average Sand-paper Drop Re-sistance Height (m) | 2. 22 | 2. 40 | 2. 27 | 2. 10 | 2. 25 |
| 2.5 m Drop Test Pass Rate (%) | 100 | 100 | 100 | 90 | 100 |
| Vickers Hard-ness, kgf/mm$^2$ | 758 | 812 | 851 | 812 | 768 |
| Fracture Toughness (MPa·m$^{1/2}$) | 1.517 | 1.604 | 1.657 | 1.598 | 1.513 |
| Failure Time at High Temperature and High Humidity, h | > 360 | > 360 | > 360 | > 360 | > 360 |

Note: 1. Since the maximum time for conducting the high temperature and high humidity failure test in the present application is 360 h (15 days), if a glass sample still does not have spots and/or foggy spots that cannot be removed by wiping when taken out for observation after 360 h, then the failure time at high temperature and high humidity of the glass sample will be determined to be greater than 360 h. 2. The surface $K_2O$ content in the table is the surface $K_2O$ concentration in the present application.

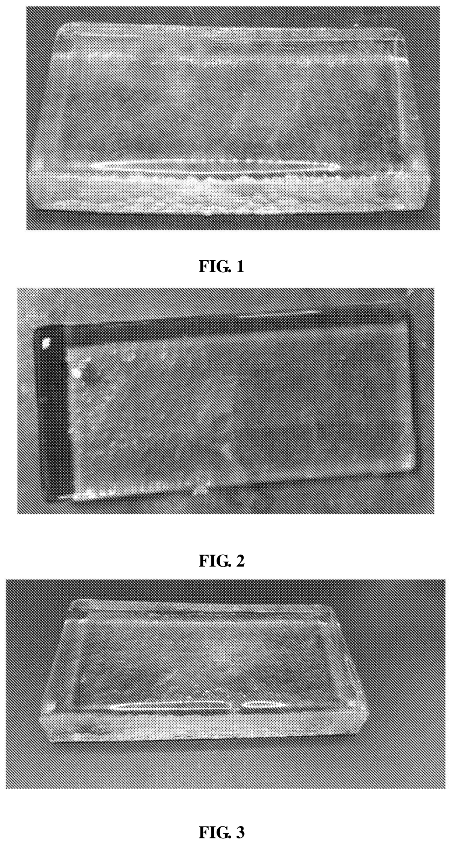

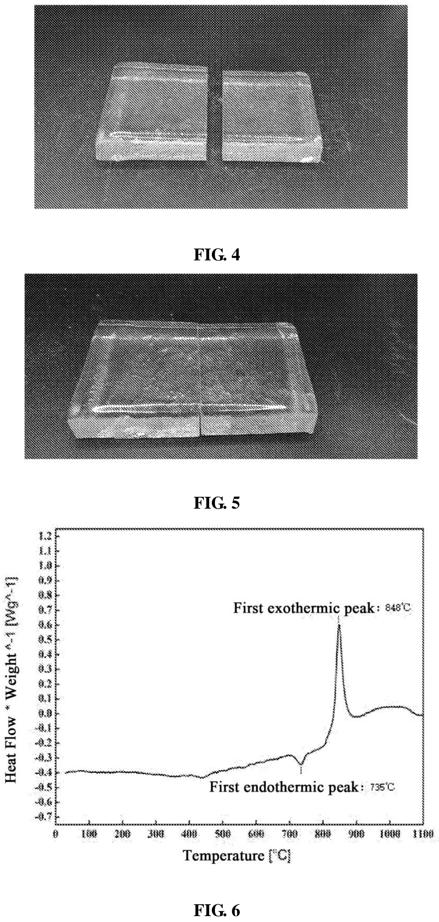

FIG. 1 shows a result of the melting process of the base glass in Example 1. FIG. 2 shows a result of the melting process of the base glass in Example 3. FIG. 3 shows a result of the melting process of the base glass in Example 4. FIG. 4 shows an appearance of the lithium-free transparent spinel glass ceramic in Example 4. FIG. 5 shows an appearance of the lithium-free transparent spinel glass ceramic in Example 5. As can be seen in Figs. 1 to 5, both the base glass prepared by the glass formulation of the present application and the lithium-free transparent spinel glass ceramic prepared under a specific heat treatment process are both transparent glass materials in the visible light range.

FIG. 6 shows a thermogravimetric analysis profile of the base glass of Example 1, wherein the test method of the thermogravimetric analysis was as follows: the base glass of Example 1 was ground and sieved through a 200-mesh sieve; the test conditions were: room temperature to 1100 °C, 10 °C/min heating rate; and the test instrument was a METTLER-TOLEDO TGA/DSC3+ Thermogravimetric and Synchronous Thermal Analyzer. The obtained raw data was imported into OriginPro software to obtain the thermogravimetric analysis profile shown in FIG. 6. As can be obtained in FIG. 6, the downward peak represents an endothermic peak, and the first endothermic peak is at 735 °C; the upward peak represents an exothermic peak, and the first exothermic peak is at 848 °C.

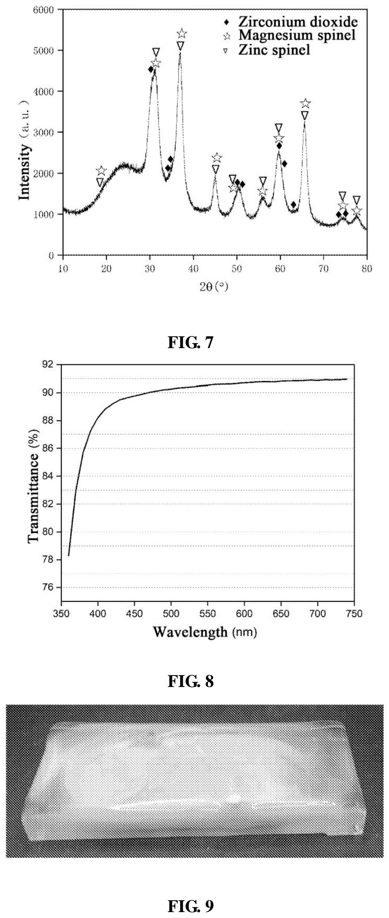

FIG. 7 shows an X-ray diffraction pattern of the lithium-free transparent spinel glass ceramic in Example 1. As can be seen in FIG. 7, the main crystalline phase of the glass ceramic is $(Zn, Mg)Al_2O_4$ (Card Nos. 74-1136 and 73-1959) and a secondary crystalline phase is zirconia (Card No. 80-1007).

FIG. 8 shows a transmittance profile of the lithium-free transparent spinel glass ceramic in Example 5 under different wavelength conditions. As can be seen from FIG. 8, at a wavelength of 550 nm, the transmittance of the glass ceramic is greater than 90%.

As can be seen from Tables 1 and 3 in combination with Figs. 1 to 3, when the base glass was prepared from the glass formulations provided by the present application, all the formulations can lead to the production of base glass through melting with good overall homogeneity and transparency. At the same time, a lithium-free transparent spinel glass ceramic with a main crystalline phase of $(Zn, Mg)Al_2O_4$ as the main crystalline phase and a secondary crystalline phase of tetragonal zirconia, high crystallinity and excellent optical performances can be prepared from the base glass produced by the present application at a heat treatment temperature of no more than 800 °C. Specifically, the crystallinity of the lithium-free transparent spinel glass ceramic produced by the present application is 37.52 to 40.41 wt.%, and the Young modulus reaches 101 GPa or more; and at a wavelength of 550 nm, the transmittance of the lithium-free transparent spinel glass ceramic prepared by the present application is greater than or equal to 89%.

As can be seen from Tables 2, 4 and 5, the lithium-free transparent spinel glass ceramic of the present application can be chemically strengthened to prepare a strengthened glass ceramic that meets specific stress characteristics, and such strengthened glass ceramic has both excellent surface stress characteristics and excellent deep-layer stress characteristics. Specifically, for the strengthened glass ceramic obtained by the present application: |CT_AV| is 73.38 to 125.91 MPa, |CT_CV| is 89.07 to 146.38 MPa, DOL_0 is 108.69 to 132.50 $\mu$m, all of which being greater than 0.13 times of the thickness of the glass (0.7 mm), CT_LD is 49620 to 80192 MPa/mm, and CS_50 is 148.02 to 337.69 MPa. The high |CT_AV|, |CT_CV|, DOL_0, CT_LD, and CS_50 indicate that the strengthened glass ceramic has excellent deep-layer stress; at the same time, the surface $K_2O$ content (i.e., the surface $K_2O$ concentration) of the strengthened glass ceramic is 9.16% to 15.21%. It should be understood that the K on the surface of strengthened glass ceramic enters to the glass surface mainly through the chemical strengthening process from the salt bath, and a higher $K_2O$ content on the surface indicates more K-Na exchange was occurred during the strengthening process, thereby resulting in a higher surface compressive stress that can be obtained by the strengthening of glass ceramic, as well as a better surface compressive stress. By testing the sandpaper drop impact resistance of the strengthened glass ceramic which meets the specific stress characteristics, it can be found that the average sandpaper drop resistance height (120-mesh sandpaper) of the strengthened glass ceramic can be 2 m or more. Besides, in the drop test at a fixed height of 2.5 m, the pass rate of the strengthened glass ceramic of the present application is greater than or equal to 70%.

In addition, the failure time at high temperature and high humidity of the strengthened glass ceramic of the present application can reach 360 h or more, indicating that the strengthened glass ceramic of the present application has an excellent weather resistance.

Comparative Examples 1 to 6 were operated under the same operating conditions as in Example 1 and were tested accordingly. Table 6 shows the composition of the glass formulations and the results of melting process of the prepared base glass in Comparative Examples 1 to 6.

Table 6 the composition of each glass formula and the results of melting process of the prepared base glass in Comparative Examples 1-6

| Scheme Number | Comparative Example 1 | Comparative Example 2 | Comparative Example 3 | Comparative Example 4 | Comparative Example 5 | Comparative Example 6 |
|---|---|---|---|---|---|---|
| Base Glass Formulation (in mol% of the oxides) | Formulation 11 | Formulation 12 | Formulation 13 | Formulation 14 | Formulation 15 | Formulation 16 |
| $SiO_2$ | 38. 81 | 38. 37 | 45. 58 | 40. 80 | 38. 44 | 38. 48 |
| $Al_2O_3$ | 27. 12 | 33. 65 | 26. 09 | 26. 31 | 26.31 | 25. 31 |
| $ZrO_2$ | 3. 33 | 3.42 | 3.57 | 5. 69 | 3. 12 | 3. 12 |
| MgO | 5. 55 | 5.75 | 5. 95 | 5.54 | 8. 82 | 7. 82 |
| ZnO | 9. 52 | 9. 71 | 10.21 | 9. 52 | 10. 41 | 14. 41 |
| $Na_2O$ | 14. 58 | 7. 30 | 7. 61 | 7. 39 | 6. 66 | 7. 66 |
| $K_2O$ | 0. 00 | 0.00 | 0.00 | 0. 00 | 0.00 | 0. 00 |
| $B_2O_3$ | 1. 09 | 1. 80 | 0. 99 | 4.75 | 5. 20 | 3.20 |
| $Y_2O_3$ | 0.00 | 0.00 | 0.00 | 0.00 | 0.00 | 0. 00 |
| BaO | 0. 00 | 0. 00 | 0.00 | 0. 00 | 1. 04 | 0. 00 |
| $Al_2O_3$-MgO-ZnO, mol% | 12. 05 | 18. 19 | 9. 93 | 11. 25 | 7. 08 | 3. 08 |
| X, % | 38. 04 | 58. 18 | 32. 53 | 36. 80 | 25. 91 | 12. 34 |
| Y, % | 91. 77 | 79. 89 | 59. 93 | 62. 64 | 53. 55 | 50. 03 |
| A | 0. 15 | 0. 24 | 0. 21 | 0. 19 | 0.10 | 0.13 |
| B | 0. 89 | 0.62 | 0.62 | 0. 64 | 0. 84 | 1.05 |

(continued)

| Scheme Number | Comparative Example 1 | Comparative Example 2 | Comparative Example 3 | Comparative Example 4 | Comparative Example 5 | Comparative Example 6 |
|---|---|---|---|---|---|---|
| Base Glass Formulation (in mol% of the oxides) | Formulation 11 | Formulation 12 | Formulation 13 | Formulation 14 | Formulation 15 | Formulation 16 |
| Result of Melting Process | Ceramization | Large Amount of Unmelted Materials | White Precipitate | White Precipitate | Ceramization | Ceramization |

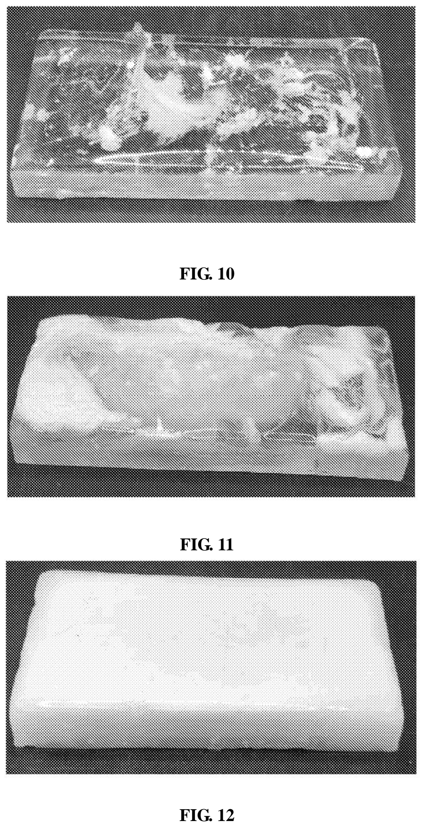

As can be seen from Table 6, the B-value in Comparative Example 1 is 0.89, which is greater than 0.8. The result of melting process is as shown in FIG. 9, and the base glass underwent ceramization after melting. In Comparative Example 2, the $Al_2O_3$ content is too high, the $B_2O_3$ content is relatively low, and the A-value is 0.24, which is greater than 0.18; and consequently melting defects occurred. As shown in FIG. 10, a large amount of unmelted materials appeared in the base glass after melting. In Comparative Example 3, the $B_2O_3$ content is relatively low and the A-value is 0.21, which is greater than 0.18. As shown in FIG. 11, white precipitate appeared in the base glass after melting. In Comparative Example 4, the $ZrO_2$ content is too high, and the A-value is 0.19, which is greater than 0.18; and white precipitate appeared in the base glass after melting. In Comparative Example 5, the MgO content is relatively high and the B-value is 0.84, which is greater than 0.8; and the base glass underwent ceramization after melting. In Comparative Example 6, the ZnO content is relatively high, and the B-value is 1.05, which is greater than 0.8. As shown in the result of melting process in FIG. 12, the base glass underwent ceramization after melting.

Comparative Examples 7 to 13 were operated under the same operating conditions as in Example 1 and were tested accordingly. Table 7 shows the glass formulations for preparing the base glass, results of melting process, heat treatment processes and performance parameters of the glass ceramic prepared in Comparative Examples 7 to 13. Table 8 shows the chemical strengthening conditions of the glass ceramic prepared in Comparative Examples 7 to 12 and the performance parameters of the strengthened glass ceramic produced. Among them, the glass formulations of Comparative Example 9 and Comparative Example 13 were the same, i.e., the prepared base glasses were the same. Comparative Example 9 was not subjected to nucleation treatment and was only subjected to a one-step heat treatment, i.e., it was directly subjected to a crystallization treatment via heating. Comparative Example 13 was crystallized at 800 °C for 240 min, but instead of precipitating crystals, there was a phase separation and a decrease in the transmittance. Comparative Example 12 was not subjected to a separate nucleation treatment. Comparative Example 9 and Comparative Example 13 were not subjected to the ion-exchange strengthening treatment. Comparative Example 7 was strengthened by treating with two conditions: 450°C×100%$NaNO_3$×9 h and 450°C ×30%$NaNO_3$+70%$KNO_3$×8 h, respectively.

Table 7 Base glass formulations, results of melting process, heat treatment processes and performance parameters of glass ceramic prepared therefrom of Comparative Examples 7 to 13

| Scheme Number | Comparative Example 7 | Comparative Example 8 | Comparative Example 9 | Comparative Example 10 | Comparative Example 11 | Comparative Example 12 | Comparative Example 13 |
|---|---|---|---|---|---|---|---|
| | Formulation 17 | Formulation 18 | Formulation 19 | Formulation 20 | Formulation 21 | Formulation 22 | Formulation 19 |
| **Base Glass Formulation (in mol% of the oxides)** | | | | | | | |
| $SiO_2$ | 69.20 | 70.00 | 46.36 | 43.02 | 40.45 | 39.60 | 46.36 |
| $Al_2O_3$ | 4.22 | 10.00 | 26.53 | 23.23 | 26.75 | 25.20 | 26.53 |
| $P_2O_5$ | 0.95 | 0.00 | 0.00 | 0.00 | 0.00 | 0.00 | 0.00 |
| $ZrO_2$ | 1.70 | 0.00 | 3.63 | 3.44 | 3.32 | 4.90 | 3.63 |
| $MgO$ | 0.00 | 6.00 | 6.05 | 5.73 | 5.54 | 6.60 | 6.05 |
| $ZnO$ | 0.00 | 0.00 | 10.39 | 9.84 | 9.52 | 12.00 | 10.39 |
| $Na_2O$ | 1.58 | 3.50 | 2.01 | 9.02 | 8.09 | 5.20 | 2.01 |
| $K_2O$ | 0.00 | 2.00 | 0.00 | 0.00 | 0.00 | 0.00 | 0.00 |
| $Li_2O_3$ | 20.73 | 8.50 | 0.00 | 0.00 | 0.00 | 0.00 | 0.00 |
| $B_2O_3$ | 1.62 | 0.00 | 5.03 | 5.72 | 4.12 | 6.50 | 5.03 |
| $Ba0$ | 0.00 | 0.00 | 0.00 | 0.00 | 2.21 | 0.00 | 0.00 |
| $Al_2O_3$-$MgO$-$ZnO_2$ mol% | - | - | 10.09 | 7.66 | 11.69 | 6.60 | 10.09 |
| X, % | - | - | 33.37 | 24.59 | 38.15 | 23.94 | 33.37 |
| Y, % | - | - | 37.15 | 58.31 | 66.64 | 44.77 | 37.15 |
| A | - | - | 0.16 | 0.06 | 0.12 | 0.13 | 0.16 |
| B | - | - | 0.45 | 0.73 | 0.66 | 0.78 | 0.45 |
| **Result of Melting Process** | Transparent | Transparent | Transparent | Transparent | Transparent | Transparent | Transparent |
| Heat Treatment Process | Comparative Example 7 | Comparative Example 8 | Comparative Example 9 | Comparative Example 10 | Comparative Example 11 | Comparative Comparative Example Example 12 13 | |
| Nucleation Temperature/ Nucleation Time | 550°C /240mi n | - | - | 700°C /240min | 710°C /240min | - | - |
| Crystallization Temperature/ Crystallization Time | 680°C /240mi n | - | 900°C /240mi n | 750°C /240min | 780°C /240min | 850°C /240min | 800°C /240min |
| Heating Rate, K/min | 10 | - | 10 | 10 | 10 | 10 | 10 |

(continued)

| Performance Parameter | Comparative Example 7 | Comparative Example 8 | Comparative Example 9 | Comparative Example 10 | Comparative Example 11 | Comparative Example 12 | Comparative Example 13 |
|---|---|---|---|---|---|---|---|
| Crystalline Phase A | $Li_2Si_2O_5$ | - | $(Zn, Mg)Al_2O_3$ | $(Zn, Mg)Al_2O_3$ | $(Zn, Mg)Al_2O_4$ | $(Zn, \mathbf{Mg})Al_2O_4$ | Non-Crystalline Phase |
| Crystalline Phase B | $LiAlSi_4O_{10}$ | - | $ZrO_2$ | $ZrO_2$ | $ZrO_2$ | $ZrO_2$ | |
| Crystalline Phase C | - | - | Mullite | - | - | - | |
| Average Crystal Size, nm | 19.6 | - | 64. 7 | 5.6 | 5.8 | 7.1 | - |
| Crystallinity, wt% | 86.56 | - | 58.85 | 39.67 | 35.11 | 42.40 | - |
| b-value | 0.60 | 0.10 | 18.38 | 0.77 | 0.50 | 0.68 | 16.58 |
| 550 nm Transmittance (%) | 91 27 | 91.57 | 54.75 | 89.60 | 89.95 | 89.83 | 57.62 |
| Young modulus (GPa) | 94 | 84 | 108 | 112 | 116 | 105 | - |
| Density, g/cm$^3$ | 2.4802 | 2.4041 | 3.0321 | 3.0052 | 3.0058 | 3.0532 | 2.9576 |

Table 8 Chemical strengthening conditions of the glass ceramic and performance parameters of the strengthened glass ceramic prepared therefrom of Comparative Examples 7 to 12

| Scheme Number | Comparative Example 7 | | Comparative Example 8 | Comparative Example 10 | Comparative Example 11 | Comparative Example 12 |
|---|---|---|---|---|---|---|
| Glass Ceramic Thickness,mm | 0.7 | | 0.7 | 0.7 | 0.7 | 0.7 |
| Ion Exchange Method | Strengthening Means 1: Single-Step Strengthening<br><br>TOX: 450°C $\times$ 100% $NaNO_3$ $\times$ 9h | Strengthening Means 2: Single-Step Strengthening<br>IOX: 450 °C $\times$ 30% NaNO3+70% $KNO_2$ $\times$ 8h | Two-Step Strengthening<br><br>I0X1:430°C $\times$100%NaNO3 $\times$ 5h, IOX2: 430°C $\times$ 100% $KNO_2$ $\times$0.67h, | Single-Step Strengthening<br><br>IOX:480°C $\times$ 100%KN $O_3$ $\times$ 24h | Single-Step Strengthening<br><br>IOX:480°C $\times$ 100%KN $O_3$ $\times$ 24h | Single-Step Strengthening<br><br>TOX:480°C $\times$ 100%K $NO_3$ $\times$ 24h |
| [CT_CV], MPa | 73.42 | 62.92 | 84.12 | 77.62 | 47.99 | 68.62 |
| CS_50, MPa | 167.98 | 93.29 | 124.32 | 194.55 | 31.75 | 168.4 5 |
| DOL_0, $\mu$m | 123.19 | 128.56 | 128.90 | 70.56 | 60.92 | 70.65 |
| \|CT_AV\| MPa | 54.31 | 45.95 | 59.64 | 58.87 | 36.07 | 48.67 |
| CT_LD/ (M Pa/mm) | 35194 | 29072 | 37675 | 47002 | 29792 | 38846 |
| Exchange Amount, % | 0.53 | 0.47 | 0.061 | 0.48 | 0.13 | 0.25 |
| Surface $K_2O$ Content, wt% | 0 | 0.52 | - | 9.12 | 5.31 | 5.16 |
| Average Sandpaper Drop Resistance Height (m) | 2.14 | 1.98 | 1.25 | 0.82 | 0.56 | 0.76 |
| 2.5 m Drop Test Pass Rate (%) | 70 | 60 | 0 | 0 | 0 | 0 |
| Vickers Hardness kgf/mm$^2$ | 722 | 725 | 682 | 757 | 792 | 791 |
| Fracture Toughness (MPa·m$^{1/2}$) | 1.391 | 1.310 | 1.322 | 1.556 | 1.570 | 1.577 |

| Scheme Number | Comparative Example 7 | | Comparative Example 8 | Comparative Example 10 | Comparative Example 11 | Comparative Example 12 |
|---|---|---|---|---|---|---|
| Glass Ceramic Thickness,mm | 0.7 | | 0.7 | 0.7 | 0.7 | 0.7 |
| Ion Exchange Method | Strengthening Means 1: Single-Step Strengthening<br><br>TOX: 450°C × 100% $NaNO_3$ × 9h | Strengthening Means 2: Single-Step Strengthening<br><br>IOX: 450 °C × 30% NaNO3+70% $KNO_2$ × 8h | Two-Step Strengthening<br><br>IOX1:430°C ×100%NaNO3 × 5h, IOX2: 430°C × 100% $KNO_2$ ×0.67h, | Single-Step Strengthening<br><br>IOX:480°C × 100%KN $O_3$ × 24h | Single-Step Strengthening<br><br>IOX:480°C × 100%KN $O_3$ × 24h | Single-Step Strengthening<br><br>TOX:480°C × 100%K $NO_3$ × 24h |
| Failure Time at High Temperature and High Humidity, h | 72 | 168 | > 360 | > 360 | > 360 | > 360 |

Note: 1. Since the maximum time for conducting the high temperature and high humidity failure test in the present application is 360 h (15 days), if a glass sample still does not have spots and/or foggy spots that cannot be removed by wiping when taken out for observation after 360 h, then the failure time at high temperature and high humidity of the glass sample will be determined to be greater than 360 h. 2. The surface $K_2O$ content in the table is the surface $K_2O$ concentration in the present application.

**EP 4 644 344 A1**

It should be noted that the glass formulation of Comparative Example 8 contains $K_2O$, and therefore, the measured surface $K_2O$ content is not entirely the result of ion exchange. Thus, no value for the surface $K_2O$ content of Comparative Example 8 is given in Table 8.

Comparative Examples 14 to 19 were operated under the same operating conditions as in Example 1 and were tested accordingly. Table 9 shows the glass formulations for preparing the base glass, results of melting process, heat treatment processes and performance parameters of the glass ceramic prepared therefrom of Comparative Examples 14 to 19. Table 10 shows chemical strengthening conditions of the glass ceramic and performance parameters of the strengthened glass ceramic prepared therefrom of Comparative Examples 14 to 16. In addition, Comparative Examples 17 to 19 were not subjected to strengthening.

Table 9 Base glass formulations, results of melting process, heat treatment processes and performance parameters of the glass ceramic prepared therefrom of Comparative Examples 14 to 19

| Scheme Number | Comparative Example 14 | Comparative Example 15 | Comparative Example 16 | Comparative Example 17 | Comparative Example 18 | Comparative Example 19 |
|---|---|---|---|---|---|---|
| Substrate Glass Formulation | Formulation 23 | Formulation 24 | Formulation 25 | Formulation 26 | Formulation 27 | Formulation 28 |
| (in mol% of the oxides) | | | | | | |
| $SiO_2$ | 45.80 | 45.19 | 41.18 | 40.94 | 41.53 | 41.61 |
| $Al_2O_3$ | 24.90 | 25.00 | 25.58 | 25.70 | 26.13 | 25.82 |
| $ZrO_2$ | 3.60 | 3.61 | 3.15 | 3.19 | 3.19 | 3.71 |
| MgO | 5.70 | 5.72 | 5.30 | 4.63 | 6.14 | 7.30 |
| ZnO | 9.90 | 9.94 | 8.61 | 9.84 | 7.54 | 10.40 |
| $Na_2O$ | 7.10 | 7.13 | 7.33 | 9.04 | 9.61 | 3.16 |
| $Li_2O$ | 0.00 | 0.00 | 0.00 | 0.00 | 0.00 | 8.00 |
| $B_2O_3$ | 3.00 | 0.00 | 8.85 | 6.66 | 5.86 | 0.00 |
| $TiO_2$ | 0.00 | 2.21 | 0.00 | 0.00 | 0.00 | 0.00 |
| BaO | 0.00 | 1.20 | 0.00 | 0.00 | 0.00 | 0.00 |
| $Al_2O_3$-MgO-ZnO, mol% | 9.30 | 9.34 | 11.67 | 11.23 | 12.45 | 8.12 |
| X, % | 29.95 | 31.81 | 35.50 | 34.75 | 37.65 | 32.24 |
| Y, % | 55.08 | 58.49 | 59.10 | 65.75 | 69.63 | 43.77 |
| A | 0.16 | 0.23 | 0.00 | 0.04 | 0.06 | 0.27 |
| B | 0.59 | 0.57 | 0.61 | 0.70 | 0.63 | 0.55 |
| Result of Melting Process | Transparent | Transparent | Transparent | Transparent | Transparent | Transparent |
| Heat Treatment Process | Comparative Example 14 | Comparative Example 15 | Comparative Example 16 | Comparative Example 17 | Comparative Example 18 | Comparative Example 19 |
| Nucleation Temperature/ Nucleation Time | 720°C /240min | - | 660°C /240min | 690°C /240min | 720°C /240min | 690°C /240min |
| Crystallization Temperature/ Crystallization Time | 820°C /240min | 1000°C /240min | 730°C /240min | 740°C /240min | 820°C /240min | 740°C /240min |

(continued)

| Result of Melting Process | Transparent | Transparent | Transparent | Transparent | Transparent | Transparent |
|---|---|---|---|---|---|---|
| Heat Treatment Process | Comparative Example 14 | Comparative Example 15 | Comparative Example 16 | Comparative Example 17 | Comparative Example 18 | Comparative Example 19 |
| Heating Rate, K/min | 10 | 10 | 10 | 10 | 10 | 10 |
| Performance Parameter | Comparative Example 14 | Comparative Example 15 | Comparative Example 16 | Comparative Example 17 | Comparative Example 18 | Comparative Example 19 |
| Crystalline Phase A | $(Zn, Mg) Al_2O_4$ | $(Zn, Mg) Al_2O_4$ | $(Zn, Mg) Al_2O_3$ | $(Zn, Mg) Al_2O_3$ | $(Zn, Mg) Al_2O_4$ | $(Zn, Mg) Al_2O_4$ |
| Crystalline Phase B | $ZrO_2$ | $ZrO_2$ | $ZrO_2$ | $ZrO_2$ | $ZrO_2$ | $ZrO_2$ |
| Crystalline Phase C | - | - | - | - | Quartz ss $(MgAl_2Si_3O_{10})$ | Quartz ss $(MgAl_2Si_3O_{10})$ |
| Average Crystal Size, nm | 6.8 | 7.2 | 7.1 | 12.1 | 22.1 | 26.0 |
| Crystallinity, wt% | 35.49 | 45.70 | 35.47 | 33.49 | 54.21 | 55.58 |
| b-value | 0.72 | 2.20 | 0.86 | 11.15 | 21.93 | 20.16 |
| 550 nm Transmittance (%) | 89.62 | 87.70 | 89.94 | 57.79 | 35.16 | 41.26 |
| Young modulus (GPa) | 101 | 99 | 112 | 107 | - | - |
| Density, $g/cm^3$ | 3.0422 | 3.056 | 2.9964 | 3.0354 | 3.1032 | 3.0385 |

Table 10 Chemical strengthening conditions of the glass ceramic and performance parameters of the strengthened glass ceramic prepared therefrom of Comparative Examples 14 to 16

| | Comparative Example 14 | Comparative Example 15 | Comparative Example 16 |
|---|---|---|---|
| Glass Ceramic Thickness, mm | 0.7 | 0.7 | 0.7 |
| Ion Exchange Method | Single-Step Strengthening IOX: 480°C × 100% $KNO_3$ × 24h | Single-Step Strengthening 10X: 480°C × 100% $KNO_3$ × 24h | Single-Step Strengthening IOX: 480°C × 100% KNO, × 24h |
| [CT_CV], MPa | 85.62 | 61.29 | 60.66 |
| CS_50, MPa | 215.40 | 73.19 | 124.75 |
| DOL_0, μm | 85.98 | 65.61 | 100.97 |
| [CT_AV]/MPa | 60.25 | 38.28 | 52.98 |
| CT_LD/ (MPa/mm) | 45449 | 31104 | 37696 |
| Exchange Amount, % | 0.36 | 0.23 | 0.29 |
| Surface $K_2O$ Content, wt% | 8.11 | 5.21 | 6.52 |
| Average Sandpaper Drop Resistance Height (m) | 1.35 | 0.60 | 1.02 |

(continued)

| | Comparative Example 14 | Comparative Example 15 | Comparative Example 16 |
|---|---|---|---|
| Glass Ceramic Thickness, mm | 0.7 | 0.7 | 0.7 |
| Ion Exchange Method | Single-Step Strengthening IOX: 480°C × 100% $KNO_3$ × 24h | Single-Step Strengthening 10X: 480°C × 100% $KNO_3$ × 24h | Single-Step Strengthening IOX: 480°C × 100% KNO, × 24h |
| 2.5m Drop Test Pass Rate (%) | 0 | 0 | 0 |
| Vickers Hardness, $kgf/mm^2$ | 798 | 786 | 732 |
| Fracture Toughness ($MPa·m^{1/2}$) | 1.578 | 1.562 | 1.479 |
| Failure Time at High Temperature and High Humidity, h | > 360 | > 360 | > 360 |

Note: 1. Since the maximum time for conducting the high temperature and high humidity failure test in the present application is 360 h (15 days), if a glass sample still does not have spots and/or foggy spots that cannot be removed by wiping when taken out for observation after 360 h, then the failure time at high temperature and high humidity of the glass sample will be determined to be greater than 360 h. 2. The surface $K_2O$ content in the table is the surface $K_2O$ concentration of the present application.

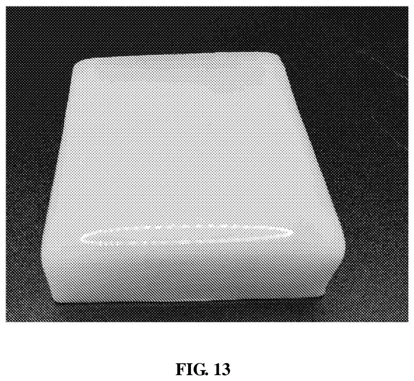

It can be seen from Table 7 and Table 9 that the $Na_2O$ content in Comparative Example 9 is relatively low. When the heat treatment temperature is lower than 800 °C, no crystalline phase appeared in the glass after heat treatment. When the heat treatment temperature reaches 900 °C, mullite impurity phase appeared after crystallization treatment, and the final glass ceramic sample has a low transmittance, showing devitrification. The content of MgO in Comparative Example 17 is relatively low, and the glass ceramic sample after crystallization has a too large average grain size, a low transmittance, and a poor optical performance of the sample. In Comparative Example 18, the content of ZnO is relatively low, and the glass ceramic sample after crystallization has a too large average grain size and there are impurity phases. Besides, the transmittance is low and the sample has a poor optical performance. In Comparative Example 19, the content of $Li_2O$ is relatively high, and the glass ceramic sample after crystallization is seriously fogged as a whole, the average grain size is too large, and quartz solid solution (quartz ss) impurity phase appeared. As shown in FIG. 13, the transmittance is low, and the sample has an extremely poor optical performance.

From Tables 8 and 10, it can be seen that Comparative Example 10 has a relatively low $Al_2O_3$ content, and the strengthened glass ceramic finally prepared has a low stress level and a poor drop impact resistance performance. In Comparative Example 12, the X-value was 23.94%, the Y-value was 44.77%, and in Comparative Example 14, the X-value was 29.95%, and the Y-value was 55.08%, all of which failed to meet the conditions of X = 30 to 50% and Y = 60 to 80%. Further, the strengthened glass ceramic finally prepared by the two comparative examples also have poor stress levels. Specifically, when using a 120-mesh sandpaper for drop test, the average sandpaper drop resistance heights of the strengthened glass ceramic of Comparative Example 12 and Comparative Example 14 are both lower than 1.4 m, which are far inferior to that of the strengthened glass ceramic prepared in the examples of the present application. Meanwhile, when the strengthened glass ceramic of Comparative Example 12 and Comparative Example 14 are subjected to the drop test at a fixed height of 2.5 m, the glass samples were broken, with a pass rate of 0. In Comparative Example 15, the Y-value does not meet the requirement of 60 to 80%. Besides, the composition comprises BaO, and the content of $Al_2O_3$ does not meet the requirements of the present application as well. Finally, the strengthened glass ceramic prepared in Comparative Example 15 has a poor stress level. In the drop test using a 120-mesh sandpaper, the average sandpaper drop resistance height was 0.6 m, which is much lower than that of the strengthened glass ceramic prepared in the examples of the present application. Further, when subjected to the drop test at a fixed height of 2.5 m, the pass rate of strengthened glass ceramic in Comparative Example 15 was 0 as well. The X-value of Comparative Example 11 is 38.15%, and the Y-value is 66.64%, but the composition comprises 2.21 mol% of BaO, and the stress level obtained after final strengthening is low, resulting in poor impact resistance performance. In Comparative Example 16, the X-value is 35.50%, and the Y-value is 59.10%, wherein the X-value meets the requirement of 30 to 50%, but the Y-value does not meet the requirement of 60 to 80%. Thus, the prepared strengthened glass ceramic has a poor deep-layer stress level, and in the drop test using a 120-mesh sandpaper, the average sandpaper drop resistance height was 1.02 m, which is much lower than that of the strengthened glass ceramic prepared in the examples of the present application.

To sum up, the strengthened glass ceramic prepared from the lithium-free transparent glass ceramic of the present application has excellent mechanical performances, such as excellent drop resistance performance. Specifically, the average sandpaper drop resistance heights (tested by a 120-mesh sandpaper) of the strengthened glass ceramic of the present application are all 2 m or more. In the drop test at a fixed height of 2.5 m, the pass rates of the strengthened glass ceramic of the present application are all greater than or equal to 70%. The drop resistance level is comparable to that of the lithium-aluminum-silicon strengthened glass ceramic with high crystallinity of Comparative Example 7, and is much higher than that of the conventional glass that was subjected to a two-step strengthening in Comparative Example 8.

Furthermore, since $Li_2O$ is not used in the present application, the raw material cost is much lower than that of Comparative Example 7 and Comparative Example 8, and has a very considerable practical value. Moreover, a transparent glass ceramic with a main crystalline phase of zinc-magnesium spinel solid solution, excellent optical performance and high intrinsic strength can be obtained from the base glass prepared using the glass formulations of the present application at a heat treatment temperature of no more than 800 °C. This greatly reduces the difficulty of mass production of the transparent spinel glass ceramic, making the mass production more likely, and aligns with the industry's developing demand for energy efficiency and carbon reduction.

As a final note, the above preferred embodiments are only used to illustrate the technical solutions of the present application and not to limit them, and although the present application has been described in detail by the above preferred embodiments, it should be understood by those skilled in the art that a wide variety of changes can be made thereto in terms of form and details without departing from the scope defined by the claims of the present application.

**Claims**

1. A lithium-free transparent spinel glass ceramic, wherein the lithium-free transparent spinel glass ceramic is prepared from a base glass by heat treatment, the lithium-free transparent spinel glass ceramic comprises a spinel crystal, and the spinel crystal is the main crystalline phase of the glass ceramic;

   the composition of the lithium-free transparent spinel glass ceramic comprises the following oxides in mol%: $SiO_2$ 38.00 mol% to 48.00 mol%, $Al_2O_3$ 25.50 mol% to 30.00 mol%, $ZrO_2$ 3.00 mol% to 5.00 mol%, MgO 5.00 mol% to 8.00 mol%, ZnO 8.00 mol% to 14.00 mol%, $Na_2O$ 7.20 mol% to 14.00 mol%, $B_2O_3$ 3.00 mol% to 8.00 mol%, $K_2O$ 0 to 2.00 mol% and $Y_2O_3$ 0 to 1.00 mol%; and
   wherein the lithium-free transparent spinel glass ceramic is substantially free of $Li_2O$, with less than 0.01% $Li_2O$ in mol%.

2. The lithium-free transparent spinel glass ceramic according to claim 1, wherein the composition of the lithium-free transparent spinel glass ceramic comprises the following oxides in mol%: $SiO_2$ 38.00 mol% to 44.00 mol%, $Al_2O_3$ 25.50 mol% to 30.00 mol%, $ZrO_2$ 3.00 mol% to 4.00 mol%, MgO 5.00 mol% to 7.00 mol%, ZnO 8.00 mol% to 12.00 mol%, $Na_2O$ 7.20 mol% to 13.00 mol%, $B_2O_3$ 3.00 mol% to 7.00 mol%, $K_2O$ 0 to 2.00 mol% and $Y_2O_3$ 0 to 1.00 mol%.

3. The lithium-free transparent spinel glass ceramic according to claim 1 or 2, wherein, in molar percentage of each oxide in the composition of the lithium-free transparent spinel glass ceramic, the composition of the lithium-free transparent spinel glass ceramic satisfies:

   for an A-value calculated based on the following formula (1), the A-value is less than or equal to 0.18, and preferably the A-value is 0.05 to 0.15,

$$(1)\ A=0.65\times Al_2O_3+3.5\times ZrO_2-0.8\times Na_2O-2.5\times B_2O_3;$$

   and/or,
   for a B-value calculated based on the following formula (2), the B-value is less than or equal to 0.80, and preferably the B-value is 0.60 to 0.78,

$$(2)\ B=3.8\times Na_2O+B_2O_3+4.5\times MgO+6.0\times ZnO-0.4\times Al_2O_3-SiO_2.$$

4. The lithium-free transparent spinel glass ceramic according to any one of claims 1 to 3, wherein the molar percentage of $Na_2O$ is 7.20 mol% to 12.00 mol%;

   and/or, the molar percentage of $Al_2O_3$ is 25.50 mol% to 28.00 mol%;
   and/or, the molar percentage of MgO is 5.00 mol% to 6.50 mol%;
   and/or, the molar percentage of ZnO is 8.00 mol% to 10.50 mol%;

and/or, the molar percentage of $B_2O_3$ is 3.00 mol% to 6.50 mol%.

5. The lithium-free transparent spinel glass ceramic according to any one of claims 1 to 4, wherein, in the lithium-free transparent spinel glass ceramic, the molar percentages of the components $Al_2O_3$, MgO and ZnO satisfy the following relationship: $Al_2O_3$-MgO-ZnO = 8.00 mol% to 15.00 mol%.

6. The lithium-free transparent spinel glass ceramic according to any one of claims 1 to 5, wherein, in molar percentage of each oxide in the composition of the lithium-free transparent spinel glass ceramic, the composition of the lithium-free transparent spinel glass ceramic satisfies:

   for an X-value calculated based on the following formula (3), the X-value is 30.00% to 50.00%, and preferably the X-value is 34.00% to 46.00%,

   $$(3)\ X=2.1\times(Al_2O_3\text{-}MgO\text{-}ZnO)/(SiO_2+Al_2O_3\text{-}MgO\text{-}ZnO+Na_2O+K_2O+B_2O_3),$$

   and/or,
   for a Y-value calculated based on the following formula (4), the Y-value is 60.00% to 80.00%, and preferably the Y-value is 60.00% to 75.00%,

   $$(4)\ Y=(2.7\times Na_2O+1.8\times(Al_2O_3\text{-}MgO\text{-}ZnO))/(SiO_2+Al_2O_3\text{-}MgO\text{-}ZnO+Na_2O+K_2O+B_2O_3).$$

7. The lithium-free transparent spinel glass ceramic according to any one of claims 1 to 6, wherein the spinel crystal is $(Zn, Mg)Al_2O_4$;
   and/or, the lithium-free transparent spinel glass ceramic further comprises tetragonal zirconia as a secondary crystalline phase.

8. The lithium-free transparent spinel glass ceramic according to any one of claims 1 to 7, wherein the crystallinity of the lithium-free transparent spinel glass ceramic is $\geq 20.00$ wt.%; preferably, the crystallinity is 20.00 wt.% to 50.00 wt.%; further preferably, the crystallinity is 30.00 wt.% to 50.00 wt.%; and more preferably, the crystallinity is 35.00 wt.% to 45.00 wt.%.

9. The lithium-free transparent spinel glass ceramic according to any one of claims 1 to 8, wherein, in the lithium-free transparent spinel glass ceramic, an average grain size is $\leq 15.0$ nm, preferably 1.0 nm to 15.0 nm, further preferably 1.0 nm to 10.0 nm, and more preferably 4.5 nm to 8.0 nm.

10. The lithium-free transparent spinel glass ceramic according to any one of claims 1 to 9, wherein, for light at a wavelength of 550 nm, the transmittance of the lithium-free transparent spinel glass ceramic with a thickness of 0.7 mm is greater than or equal to 85%, preferably greater than or equal to 89%.

11. The lithium-free transparent spinel glass ceramic according to any one of claims 1 to 10, wherein the Young modulus of the lithium-free transparent spinel glass ceramic is $\geq 100$ GPa; preferably, the Young modulus is $\geq 110$ GPa, and more preferably 114 GPa $\leq$ Young modulus $\leq 140$ GPa.

12. The lithium-free transparent spinel glass ceramic according to any one of claims 1 to 11, wherein, the optical b-value of the lithium-free transparent spinel glass ceramic with a thickness of 0.7 mm is 0.20 to 1.50, preferably 0.50 to 1.20.

13. The lithium-free transparent spinel glass ceramic according to any one of claims 1 to 12, wherein the lithium-free transparent spinel glass ceramic is substantially free of BaO, with less than 0.01% BaO in mol%;
    and/or, the lithium-free transparent spinel glass ceramic is substantially free of $TiO_2$, with less than 0.01% $TiO_2$ in mol%.

14. A preparation method of the lithium-free transparent spinel glass ceramic according to any one of claims 1 to 13, comprising the step of: subjecting a base glass to a heat treatment to form the lithium-free transparent spinel glass ceramic;

    wherein the lithium-free transparent spinel glass ceramic comprises a spinel crystal, and the spinel crystal is the main crystalline phase of the lithium-free transparent spinel glass ceramic;

the composition of the lithium-free transparent spinel glass ceramic comprises the following oxides in mol%: $SiO_2$ 38.00 mol% to 48.00 mol%, $Al_2O_3$ 25.50 mol% to 30.00 mol%, $ZrO_2$ 3.00 mol% to 5.00 mol%, MgO 5.00 mol% to 8.00 mol%, ZnO 8.00 mol% to 14.00 mol%, $Na_2O$ 7.20 mol% to 14.00 mol%, $B_2O_3$ 3.00 mol% to 8.00 mol%, $K_2O$ 0 to 2.00 mol% and $Y_2O_3$ 0 to 1.00 mol%; and

wherein the lithium-free transparent spinel glass ceramic is substantially free of $Li_2O$, with less than 0.01% $Li_2O$ in mol%.

15. The preparation method according to claim 14, wherein the heat treatment comprises a nucleation treatment and/or a crystallization treatment; wherein:

the nucleation treatment temperature is 600 °C to 850 °C, preferably 600 C to 750 °C, and preferably, the nucleation treatment time is 0 h to 72 h, preferably 0 to 24 h;

and/or, the crystallization treatment temperature is 700 °C to 1000 °C, preferably 700 °C to 800 °C, and preferably, the crystallization treatment time is 0.1 h to 72 h, preferably 0.1 h to 24 h; and/or,

during the heat treatment, the heating rate is controlled to be 5 K/min to 15 K/min.

16. The preparation method according to claim 14 or 15, wherein,

in molar percentage of each oxide in the composition of the lithium-free transparent spinel glass ceramic, the composition of the lithium-free transparent spinel glass ceramic satisfies:

$A=0.65 \times Al_2O_3+3.5 \times ZrO_2-0.8 \times Na_2O-2.5 \times B_2O_3$, wherein $A \leq 0.18$, and preferably the A-value is 0.05 to 0.15;

and/or, $B=3.8 \times Na_2O+B_2O_3+4.5 \times MgO+6.0 \times ZnO-0.4 \times Al_2O_3-SiO_2$, wherein $B \leq 0.80$, and preferably the B-value is 0.60 to 0.78;

and/or, $X=2.1 \times (Al_2O_3-MgO-ZnO)/(SiO_2+Al_2O_3-MgO-ZnO+Na_2O+K_2O+B_2O_3)$, wherein X=30.00% to 50.00%, and preferably X=34.00% to 46.00%;

and/or, $Y=(2.7 \times Na_2O+1.8 \times (Al_2O_3-MgO-ZnO))/(SiO_2+Al_2O_3-MgO-ZnO+Na_2O+K_2O+B_2O_3)$, wherein Y= 60.00% to 80.00%, preferably Y=60.00% to 75.00%;

and/or, in the lithium-free transparent spinel glass ceramic, the molar percentages of the components $Al_2O_3$, MgO and ZnO satisfy the following relationship: $Al_2O_3-MgO-ZnO$ = 8.00 mol% to 15.00 mol%.

17. The preparation method according to any one of claims 14 to 16, wherein the lithium-free transparent spinel glass ceramic is substantially free of BaO, with less than 0.01% BaO in mol%;

and/or, the lithium-free transparent spinel glass ceramic is substantially free of $TiO_2$, with less than 0.01% $TiO_2$ in mol%.

18. A base glass for preparing the lithium-free transparent spinel glass ceramic according to any one of claims 1 to 13, wherein the composition of the base glass comprises the following oxides in mol%: $SiO_2$ 38.00 mol% to 48.00 mol%, $Al_2O_3$ 25.50 mol% to 30.00 mol%, $ZrO_2$ 3.00 mol% to 5.00 mol%, MgO 5.00 mol% to 8.00 mol%, ZnO 8.00 mol% to 14.00 mol%, $Na_2O$ 7.20 mol% to 14.00 mol%, $B_2O_3$ 3.00 mol% to 8.00 mol%, $K_2O$ 0 to 2.00 mol% and $Y_2O_3$ 0 to 1.00 mol%; and

wherein the base glass is substantially free of $Li_2O$, with less than 0.01% $Li_2O$ in mol%.

19. The base glass according to claim 18, wherein, in molar percentage of each oxide in the composition of the base glass, the composition of the base glass satisfies:

$A=0.65 \times Al_2O_3+3.5 \times ZrO_2-0.8 \times Na_2O-2.5 \times B_2O_3$, wherein $A \leq 0.18$, and preferably the A-value is 0.05 to 0.15;

and/or, $B=3.8 \times Na_2O+B_2O_3+4.5 \times MgO+6.0 \times ZnO-0.4 \times Al_2O_3-SiO_2$, wherein $B \leq 0.80$, and preferably the B-value is 0.60 to 0.78;

and/or, $X=2.1 \times (Al_2O_3-MgO-ZnO)/(SiO_2+Al_2O_3-MgO-ZnO+Na_2O+K_2O+B_2O_3)$, wherein X=30.00% to 50.00%, and preferably X=34.00% to 46.00%;

and/or, $Y=(2.7 \times Na_2O+1.8 \times (Al_2O_3-MgO-ZnO))/(SiO_2+Al_2O_3-MgO-ZnO+Na_2O+K_2O+B_2O_3)$, wherein Y= 60.00% to 80.00%, preferably Y=60.00% to 75.00%;

and/or, in the base glass, the molar percentages of the components $Al_2O_3$, MgO and ZnO satisfy the following relationship: $Al_2O_3-MgO-ZnO$ = 8.00 mol% to 15.00 mol%.

20. The base glass according to claim 18 or 19, wherein the base glass is substantially free of BaO, with less than 0.01% BaO in mol%;

and/or, the base glass is substantially free of TiO$_2$, with less than 0.01% TiO$_2$ in mol%.

21. A chemically strengthened glass, comprising a chemically strengthened glass obtained by subjecting the lithium-free transparent spinel glass ceramic according to any one of claims 1 to 13, or a lithium-free transparent spinel glass prepared by the preparation method according to any one of claims 14 to 17, or the base glass according to any one of claims 18 to 20, to a chemical strengthening treatment.

22. Use of the lithium-free transparent spinel glass ceramic according to any one of claims 1 to 13, or a lithium-free transparent spinel glass prepared by the preparation method according to any one of claims 14 to 17, or the base glass according to any one of claims 18 to 20, or the chemically strengthened glass according to claim 21, in a mobile phone display screen, a tablet computer display screen, a hand-held game console, an electronic terminal, a portable digital device, a vehicle center control screen, an electronic whiteboard glass, a smart home touch screen, a vehicle windshield glass, a flight vehicle windshield glass, or an aircraft windshield glass.

**FIG. 1**

**FIG. 2**

**FIG. 3**

**FIG. 4**

**FIG. 5**

**FIG. 6**

**FIG. 7**

**FIG. 8**

**FIG. 9**

**FIG. 10**

**FIG. 11**

**FIG. 12**

**FIG. 13**

# INTERNATIONAL SEARCH REPORT

| International application No. |
|---|
| **PCT/CN2023/101602** |

| **A.** | **CLASSIFICATION OF SUBJECT MATTER** |
|---|---|

C03C 10/06(2006.01)i;  C03C 10/02(2006.01)i

According to International Patent Classification (IPC) or to both national classification and IPC

| **B.** | **FIELDS SEARCHED** |
|---|---|

Minimum documentation searched (classification system followed by classification symbols)

IPC:C03C

Documentation searched other than minimum documentation to the extent that such documents are included in the fields searched

Electronic data base consulted during the international search (name of data base and, where practicable, search terms used)

CNTXT, ENTXTC, ENTXT, VEN, Web of Science, 中国期刊网全文数据库, CJFD: 玻璃陶瓷, 二氧化硅, 尖晶石, 结晶玻璃, 晶化玻璃, 三氧化二铝, 陶瓷玻璃, 微晶玻璃, 氧化钾, 氧化铝, 氧化镁, 氧化钠, 氧化硼, 氧化锌, 氧化钇, 氧化锆, Al2O3, alumina, B2O3, K2O, magnesia, MgO, Na2O, natron, silica, SiO2, Y2O3, zirconia, ZnO, ZrO2, Al2O4, magnesium oxide, zinc white, zirconium +oxide, boric anhydride, alumin?um oxide, boron ???oxide, sodium oxide, spinel+, microcrystalline glass, zinc oxide, silicon ??oxide, Glass ceramic

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | CN 115010369 A (WUHAN UNIVERSITY OF TECHNOLOGY) 06 September 2022 (2022-09-06)<br>      description, paragraphs 0007, 0021, 0065 and 0095, embodiment 3 | 1-22 |
| A | CN 110217994 A (HUAWEI TECHNOLOGIES CO., LTD.) 10 September 2019 (2019-09-10)<br>      entire document | 1-22 |
| A | CN 111908793 A (CDGM GLASS CO., LTD.) 10 November 2020 (2020-11-10)<br>      entire document | 1-22 |
| A | CN 115286251 A (QINGYUAN CSG ENERGY SAVING NEW MATERIAL CO., LTD. et al.) 04 November 2022 (2022-11-04)<br>      entire document | 1-22 |
| A | JP 2021155268 A (NIPPON ELECTRIC GLASS CO., LTD.) 07 October 2021 (2021-10-07)<br>      entire document | 1-22 |

☑ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **18 September 2023** | **27 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/101602**

| C. | DOCUMENTS CONSIDERED TO BE RELEVANT | |
|---|---|---|
| Category* | Citation of document, with indication, where appropriate, of the relevant passages | Relevant to claim No. |
| A | US 2020172432 A1 (CORNING INC.) 04 June 2020 (2020-06-04)<br>entire document | 1-22 |

Form PCT/ISA/210 (second sheet) (July 2022)

# INTERNATIONAL SEARCH REPORT
**Information on patent family members**

International application No.

**PCT/CN2023/101602**

| Patent document cited in search report | | | Publication date (day/month/year) | Patent family member(s) | | | Publication date (day/month/year) |
|---|---|---|---|---|---|---|---|
| CN | 115010369 | A | 06 September 2022 | None | | | |
| CN | 110217994 | A | 10 September 2019 | WO | 2020192485 | A1 | 01 October 2020 |
| | | | | CN | 110217994 | B | 14 September 2021 |
| CN | 111908793 | A | 10 November 2020 | CN | 111908793 | B | 08 April 2022 |
| CN | 115286251 | A | 04 November 2022 | None | | | |
| JP | 2021155268 | A | 07 October 2021 | None | | | |
| US | 2020172432 | A1 | 04 June 2020 | KR | 20210099607 | A | 12 August 2021 |
| | | | | US | 2022298063 | A1 | 22 September 2022 |
| | | | | WO | 2020112466 | A1 | 04 June 2020 |
| | | | | EP | 3887327 | A1 | 06 October 2021 |
| | | | | US | 11370697 | B2 | 28 June 2022 |
| | | | | JP | 2022509838 | A | 24 January 2022 |
| | | | | TW | 202028138 | A | 01 August 2020 |
| | | | | CN | 113365957 | A | 07 September 2021 |

Form PCT/ISA/210 (patent family annex) (July 2022)

**REFERENCES CITED IN THE DESCRIPTION**

**Patent documents cited in the description**

- CN 202211738867

- CN 111908793 A

**Non-patent literature cited in the description**

- **ROBERT L. SMITH** ; **GEORGE E.** Sandland of Britain. Vickers Ltd, 1921